Europäisches Patentamt

European Patent Office

Office européen des brevets

(11) Veröffentlichungsnummer: **0 465 949 A2**

# EUROPÄISCHE PATENTANMELDUNG

(21) Anmeldenummer: **91110721.7**

(22) Anmeldetag: **28.06.91**

(51) Int. Cl.⁵: **G03F 7/20**, G03F 1/14

(30) Priorität: **07.07.90 DE 4021689**

(43) Veröffentlichungstag der Anmeldung:
**15.01.92 Patentblatt 92/03**

(84) Benannte Vertragsstaaten:
**DE FR GB IT**

(71) Anmelder: **BASF Aktiengesellschaft**
**Carl-Bosch-Strasse 38**
**W-6700 Ludwigshafen(DE)**

(72) Erfinder: **Bauer, Gerhard, Dr.**
**Friedrich-Fosler-Strasse 4**
**W-6940 Weinheim(DE)**
Erfinder: **Bleckmann, Gerhard**
**Giselherstrasse 9**
**W-6840 Lampertheim 5(DE)**
Erfinder: **Zuerger, Manfred**
**Holderlandstrasse 2**
**W-6920 Sinsheim(DE)**
Erfinder: **Jaeckel, Klaus-Peter, Dr.**
**Hans-Jakob-Strasse 5**
**W-7602 Oberkirch(DE)**
Erfinder: **Haarer, Dietrich, Prof. Dr.**
**Hangweg 30**
**W-8580 Bayreuth(DE)**

(54) **Lichtempfindliche Aufzeichnungselemente, Verfahren zu ihrer Herstellung und Weiterverarbeitung sowie Geräte für die Durchführung dieser Verfahren.**

(57) Die neuen lichtempfindlichen Aufzeichnungselemente (A, B, C) enthalten einen dimensionsstabilen Träger (A), eine negativ oder positiv arbeitende lichtempfindliche Aufzeichnungsschicht (B) und eine mit der Oberfläche der Aufzeichnungsschicht (B) direkt verbundene Bildmaske (C), welche ein reliefartiges Muster aus unbeschichteten und beschichteten Bereichen darstellt, wobei die beschichteten Bereiche gegenüber dem jeweils zu verwendenden aktinischen Licht im wesentlichen undurchlässig sind und aus Flüssigkeitströpfchen oder aus festen oder geschmolzenen oder in Flüssigkeiten dispergierten oder gelösten Partikeln bestehen, die auf die Oberfläche der Aufzeichnungsschicht (B) bildmäßig übertragen worden sind. Erfindungsgemäß handelt es sich bei den Flüssigkeitströpfchen und den festen oder geschmolzenen oder in Flüssigkeiten dispergierten oder gelösten Partikeln um Toner, wie sie in der Elektrophotographie verwendet werden, um Tinten, wie sie für Tintenstrahldrucker verwendet werden, oder um Pigmente und/oder Pigment/Bindemittel-Mischungen, wie sie für den Thermotransferdruck verwendet werden. Die Bildmasken (C) werden auf der Aufzeichnungsschicht (B) der lichtempfindlichen Aufzeichnungselemente (A, B) entweder mit Hilfe eines betonerten elektrophotographischen Aufzeichnungselements (D) oder mittels einer Folie, welche eine Pigment- und/oder Pigment/Bindemittel-Schicht aufweist, erzeugt, oder es werden hierzu Tintenstrahldrucker verwendet. Dadurch können Bildmasken (C) computergesteuert auf an sich bekannten lichtempfindlichen Aufzeichnungselementen (A, B) erzeugt werden, weswegen die Verwendung teurer Photomasken bei der Herstellung von Druckplatten und Photoresisten nicht mehr länger notwendig ist. Außerdem können hierbei an sich bekannte lichtempfindliche Aufzeichnungselemente (A, B) mit klebriger Oberfläche angewandt werden, welche ansonsten nur beschränkt für die herkömmlichen Abbildungsverfahren tauglich sind. Darüber hinaus wird ein Gerät beschrieben, mit dessen Hilfe sowohl die neuen lichtempfindlichen Aufzeichnungselemente (A, B, C) als auch nahtlose Druckplatten für den Endlosdruck oder endlose Photoresistbahnen durch Übertragen von Tonerbildern von elektrophotographischen Aufzeichnungselementen (D) auf an sich bekannte lichtempfindliche Aufzeichnungselemente (A, B) in besonders vorteilhafter Weise hergestellt werden können.

EP 0 465 949 A2

Gegenstand der vorliegenden Erfindung ist ein neues lichtempfindliches Aufzeichnungselement sowie neue Verfahren zu seiner Herstellung und Weiterverarbeitung zu Druckplatten und Photoresisten.

Ein weiterer Gegenstand der vorliegenden Erfindung ist ein neues Gerät, welches der Durchführung der neuen Herstell- und Weiterverarbeitungsverfahren dient.

Noch ein Gegenstand der vorliegenden Erfindung ist die neuartige Verwendung von Tonern, wie sie in der Elektrophotographie angewandt werden, von Tinten, wie sie in Tintenstrahldruckern angewandt werden, und von Pigmenten und/oder Pigment/Bindemittel-Mischungen, wie sie im Thermotransferdruck und neuerdings auch in Tintenstrahldruckern Verwendung finden, sowie die Verwendung der damit zusammenhängenden Verfahren für die Herstellung der neuen lichtempfindlichen Aufzeichnungselemente.

Lichtempfindliche Aufzeichnungselemente mit einem dimensionstabilen Träger (A) und einer lichtempfindlichen Aufzeichnungsschicht (B), deren Oberfläche von einem reliefartigen Muster aus unbeschichteten und beschichteten Bereichen bedeckt ist, ist aus der DE-A-26 38 710 bekannt. Hierbei bestehen die beschichteten Bereiche im wesentlichen aus einem gegenüber Licht nicht empfindlichen Polymeren, welches beim Entwickeln der bildmäßig belichteten lichtempfindlichen Aufzeichnungselemente (A, B) wieder weggewaschen wird, sowie aus einem lichtabsorbierenden Mittel, welches in demselben Wellenlängenbereich absorbiert wie die lichtempfindliche Aufzeichnungsschicht (B). Allerdings handelt es sich bei diesem reliefartigen Muster nicht um eine Bildmaske, welche der bildmäßigen Belichtung der lichtempfindlichen Aufzeichnungsschicht (B) des lichtempfindlichen Aufzeichnungselements dienen könnte. Das reliefartige Muster vermag lediglich die Kontaktierung des lichtempfindlichen Aufzeichnungselements mit einer konventionellen Bildmaske zu verbessern.

Ein lichtempfindliches Aufzeichnungselement (A, B, C) mit einem dimensionsstabilen Träger (A), einer lichtempfindlichen Aufzeichnungsschicht (B) und einer der Oberfläche der lichtempfindlichen Aufzeichnungsschicht (B) direkt aufliegenden Bildmaske (C') ist aus der DE-A-21 49 055 bekannt. Dieses lichtempfindliche Aufzeichnungselement (A,B,C') wird dadurch hergestellt, daß man auf die Oberfläche seiner lichtempfindlichen Aufzeichnungsschicht (B) eine Schicht aus einer feinteiligen Kristallsuspension einer photoempfindlichen Diacetylenverbindung in einem polymeren Bindemittel aufbringt. Hierbei wird darauf geachtet, daß die lichtempfindliche Aufzeichnungsschicht (B) von einer solchen Zusammensetzung ist, daß sie gegenüber aktinischem Licht eine Wellenlänge $\lambda < 320$ nm im wesentlichen unempfindlich ist. Es wird nun eine konventionelle Bild- oder Photomaske bzw. eine Negativvorlage auf die Schicht, welche die Diacetylenverbindung enthält, aufgelegt, wonach man diese Schicht mit aktinischem Licht einer Wellenlänge $\lambda$ von $< 320$ nm belichtet. Dadurch werden in dieser Schicht belichtete Bereiche erzeugt, in denen polymere Acetylene vorliegen, welche aktinisches Licht einer Wellenlänge $\lambda$ von 320 bis 450 nm zu 90 % und mehr absorbieren, d.h., daß sie gegenüber aktinischen Licht dieser Wellenlänge im wesentlichen undurchlässig sind. Demgegenüber bleiben die unbelichteten Bereiche der Schicht, in denen noch immer die Diacetylenverbindung vorliegt, für aktinisches Licht eine Wellenlänge $\lambda$ zwischen 320 und 450 nm durchlässig. Demnach stellt diese belichtete Schicht eine Bildmaske (C') dar, durch welche hindurch die darunterliegende lichtempfindliche Aufzeichnungsschicht (B) mit aktinischem Licht einer Wellenlänge $\lambda$ zwischen 320 und 450 nm bildmäßig belichtet werden kann. Hiernach können sowohl die Bildmaske (C') als auch die unbelichteten Bereiche der bildmäßig belichteten Aufzeichnungsschicht (B) mit einem Entwicklerlösungsmittel weggewaschen werden. Nachteilig für dieses Verfahren ist, daß die der Oberfläche der lichtempfindlichen Aufzeichnungsschicht (B) direkt aufliegende Bildmaske (C') nach wie vor mit Hilfe einer konventionellen Photomaske oder Negativvorlage hergestellt werden muß. Außerdem muß hierbei sehr kurzwelliges ultraviolettes aktinisches Licht verwendet werden, was allein schon aus sicherheitstechnischen Gründen von erheblichem Nachteil ist.

Ein weiteres lichtempfindliches Aufzeichnungselement, welches einen dimensionsstabilen Träger (A), eine lichtempfindliche Aufzeichnungsschicht (B) und eine der Oberfläche der lichtempfindlichen Aufzeichnungsschicht (B) direkt aufliegenden Bildmaske (C) enthält, ist aus dem Artikel "®Nyloprint BASF, Nyloprint Hochdruck - das Druckverfahren für die 80er und 90er Jahre - kann die Nyloprint Hochdruckplatte an moderne Datenübertragungssysteme angeschlossen werden? - Gibt es Möglichkeiten zur filmlosen Herstellung photopolymerer Hochdruckplatten?", in der Sonderausgabe zur IFRA-Expo 80, Spezialausgabe, Seiten 5 und 6 der Neuen Züricher Zeitung des Jahrgangs 201 bekannt. Die Bildmaske (C) dieses bekannten lichtempfindlichen Aufzeichnungselements kann zwar aus einer photopolymerisierbaren Maskenschicht durch Belichten mit einer computergesteuerten UV-Laserlichtquelle und durch Auswaschen mit einem Entwicklerlösungsmittel erzeugt werden, allerdings sind die hierbei zu verwendenden UV-Laserlichtquellen teuer und werfen sicherheitstechnische Probleme auf. Außerdem sind für die Herstellung von Druckplatten und Photoresisten aus diesem lichtempfindlichen Auszeichnungselementen zwei Auswaschschritte notwendig, was ein weiterer wesentlicher Nachteil ist.

Die Verwendung computergesteuerter Tintenstrahldrucker für die Herstellung von Proofs, welche in Größe und Farbe dem späteren Druck entsprechen, ist z.B. aus dem Artikel von Oliver Bruns, "Proofs aus digitalem Datenbestand: der Tintenstrahldrucker Iris 3024 am Response-System von Scitex", in Deutscher Drucker, Nr. 36/9.11.89, Seiten w10 bis w11, bekannt. Es wird hierin nicht vorgeschlagen, Tintenstrahldrukker direkt für die Herstellung eines lichtempfindlichen Aufzeichnungselements mit einem dimensionstabilen Träger (A), einer lichtempfindlichen Aufzeichnungsschicht (B) und einer der Oberfläche der lichtempfindlichen Aufzeichnungsschicht (B) direkt aufliegenden Bildmaske (C) zu verwenden.

Aus der US-A-3 745 586 ist ein Verfahren bekannt, welches man als "Destillationsdruck" bezeichnen mag. Hierbei wird eine dünne Folie verwendet, welche auf der einen Seite mit Tinten beschichtet ist. Diese Folie wird von ihrer unbeschichteten Seite her mit einer Laserlichtquelle bildmäßig belichtet und dabei so hoch erhitzt, daß dadurch die Tinte in den belichteten Stellen von der Folie auf eine in einem gewissen Abstand hierzu befindliche andere Oberfläche übertragen wird. Bei dieser anderen Oberfläche kann es sich um eine Druckplatte handeln, und die übertragenen Tinten können lithographische Tinten sein, so daß das durch die Tintenübertragung resultierende Element direkt im Offsetdruck verwendet werden kann. Außerdem kann dieses Verfahren für die Herstellung von Masken für Mikrochips angewandt werden. Hierbei wird ein Photoresistmaterial selektiv auf das Trägermaterial der Maske übertragen. Die Maske kann dann durch konventionelle Photoätztechniken ausgebildet werden. Weitere Details gehen aus der US-A-3 745 586 nicht hervor. Insbesondere wird die Herstellung von lichtempfindlichen Aufzeichnungselementen (A, B, C) für die Herstellung von Druckplatten nicht angesprochen.

Ein Verfahren, das demjenigen der US-A-3 745 586 in gewisser Weise ähnelt, ist aus der DE-A-35 07 418 bekannt. Bei diesem Verfahren wird oder werden eine oder mehrere verdampfbare und/oder schmelzbare Substanzen von einer Folie mit Hilfe eines computergesteuerten Thermokopfes auf eine Platte übertragen. Verwendet man hierbei eine Aluminiumplatte, wie sie üblicherweise für die Herstellung von Offsetdruckplatten verwendet wird, erhält man direkt ohne Zwischenschaltung photomechanischer Schritte eine druckfertige Offsetdruckplatte. Nachteilig ist hier die kurze Lebensdauer dieser Druckplatte unter Druckbedingungen.

Des weiteren ist die Verwendung von Tonern, wie sie in der Elektrophotographie allgemein angewandt werden, für die Herstellung von Bildmaskenfolien aus der DE-A-30 46 877 bekannt. Zur Herstellung dieser Bildmasken wird eine Polyesterfolie mit einer dünnen, leicht klebrigen, thermisch oder photochemisch vernetzbaren Schicht bedeckt. Daneben wird in an sich bekannter Weise auf der Oberfläche eines elektrophotographischen Aufzeichnungselements (D) durch Aufladen mit einer Hochspannungsentladungskorona, bildmäßiger Belichtung mit aktinischem Licht und Betonern ein Tonerbild aus Tonerpartikeln erzeugt. Bringt man nun die klebrige Oberfläche der Folie in direkten, innigen Kontakt mit dem Tonerbild, werden die Tonerpartikel auf die Folie übertragen. Danach wird die auf der Folie befindliche thermisch oder photochemisch vernetzbare Schicht vernetzt, und man erhält eine klebfreie Bildmaskenfolie, welche in üblicher und bekannter Weise als Photomaske oder Negativvorlage für die Herstellung von Druckplatten und Photoresisten aus lichtempfindlichen Aufzeichnungselementen (A,B) verwendet werden kann. In der DE-A-30 46 877 wird nicht vorgeschlagen, das Tonerbild auf dem elektrophotographischen Aufzeichnungselement (D) direkt auf ein lichtempfindliches Aufzeichnungselement (A, B) zu übertragen.

Bislang geschah die Übertragung von Bildinformationen auf lichtempfindliche Aufzeichnungselemente (A, B), welche der Herstellung von Druckplatten oder von Photoresisten dienen, fast ausschließlich durch die sogenannte Kontaktbelichtung über eine Positiv- oder Negativfilmvorlage, welche mit den in der Reproduktionstechnik üblichen Methoden hergestellt wird. Allerdings ist die Herstellung einer solchen Belichtungsvorlage oder Bildmaske und deren sachgemäße Lagerung für Wiederholungsaufträge im reprographischen Betrieb zeit- und kostenintensiv. Um eine solche Belichtungsvorlage oder Bildmaske mit der Bildinformation einwandfrei auf das lichtempfindliche Aufzeichnungselement (A, B) zu übertragen, ist für einen innigen Kontakt zwischen der Bildmaske und dem lichtempfindlichen Aufzeichnungselement (A, B) zu sorgen. Dies geschieht bislang durch einen sogenannten Vakuumtisch und eine Abdeckfolie. Auf diesem Vakuumtisch werden die Bildmaske und die Abdeckfolie fest an die Oberfläche des lichtempfindlichen Aufzeichnungselements (A, B) angesaugt. Hierbei muß diese Abdeckfolie aufgerauht sein, damit die zwischen ihr und der Bildmaske befindliche Luft überhaupt abgesaugt werden kann. Wegen dieser Aufrauhung erzeugt die Abdeckfolie aber unerwünschtes Streulicht, welches die Belichtungszeit deutlich verlängert.

Hiervon abgesehen, sind den Formaten gewisse Grenzen gesetzt, welche nicht überschritten werden können, weil die Vakuumtische nicht beliebig groß ausgelegt werden können.

Für die Herstellung besonders großflächiger Druckplatten oder Photoresiste benötigt man entsprechend große Positiv- oder Negativfilmvorlagen oder Bildmasken. üblicherweise werden diese größeren Filmformate aus Einzelbildern zusammengeklebt. Indes können solche zusammengeklebten Bildmasken nicht für die Herstellung von Tiefdruckplatten aus lichtempfindlichen Aufzeichnungselementen (A, B) verwendet werden, weil die Schnittkanten der Einzelbilder im Druckbild der Tiefdruckplatten sichtbar werden und mitdrucken .

Es müssen deshalb hier von vornherein sehr große, schnittstellenfreie Filmformate verwendet werden, was im reprographischen Betrieb erheblich höhere Kosten verursacht, als sie bei der Schnitt- und Klebtechnik anfallen.

Der Zwang, bei den konventionellen Übertragungsverfahren die Bildmaske in innigen Kontakt mit der Oberfläche des lichtempfindlichen Aufzeichnungselements (A, B) bringen zu müssen, führt zu weiteren Problemen: wenn die Oberfläche des lichtempfindlichen Aufzeichnungselements (A, B) auch nur leicht klebrig ist und/oder wenn die Bildmaske eine besonders glatte Oberfläche aufweist, läßt sich zum einen die zwischen der Bildmaske und der Oberfläche des lichtempfindlichen Aufzeichnungselements (A, B) befindliche Luft nur sehr schlecht absaugen, was die Kontaktzeit ungebührlich verlängert, zum anderen besteht die Gefahr, daß nach dem in Kontaktbringen der Bildmaske mit dem lichtempfindlichen Aufzeichnungselement (A, B), die Bildmaske nicht mehr von dessen Oberfläche abgelöst werden kann. Man muß deshalb auch hier rauhe Oberflächen verwenden, was aber noch mehr Streulicht hervorruft, als ohnedies schon vorhanden ist. Zugleich muß man Vorsorge treffen, daß die Oberfläche des lichtempfindlichen Aufzeichnungselements (A, B) nicht mehr länger klebrig ist, was insbesondere bei lichtempfindlichen Aufzeichnungselementen (A, B), welche der Herstellung von Flexodruckplatten dienen, zusätzliche entklebende Maßnahmen wie das Aufbringen einer Deckschicht erforderlich macht.

Die bildmäßige Belichtung unter Vakuum kann auch nicht bei zylinderförmigen lichtempfindlichen Aufzeichnungselementen (A, B), welche der Herstellung endlos beschichteter Druckzylinder dienen, angewandt werden. Für die Herstellung solcher endlos beschichteter Druckzylinder aus zylinderförmigen lichtempfindlichen Aufzeichnungselementen (A, B) müssen die Bildmasken mit einer umgelenkten transparenten Folie, welche etwa ein zehntel des Zylinderumfangs umspannt, auf das lichtempfindliche Aufzeichnungselement (A, B) gepreßt und weitertransportiert werden. Dabei kann Luft zwischen der Bildmaske und der Oberfläche des lichtempfindlichen Aufzeichnungselements (A, B) eingeschlossen werden, was eine einwandfreie Übertragung der Bildinformation verhindert. Auch hier muß dafür gesorgt werden, daß die Oberfläche des zylinderförmigen lichtempfindlichen Aufzeichnungselements (A, B) klebfrei ist.

Zwar gibt es bereits verschiedene Wege, Bildinformationen ohne Umweg über eine Positiv- oder einen Negativfilmvorlage, d.h. über eine Bildmaske, auf Aufzeichnungselemente, welche der Herstellung von Druckplatten und Photoresisten dienen, zu übertragen. So werden z.B. bei der Herstellung von Tiefdruckplatten Informationen direkt vom Computer mittels Gravur auf metallische Druckzylinder übertragen. Was lichtempfindliche Aufzeichnungselemente (A, B) betrifft, führen die bislang bekannten Verfahren zur Bildinformationsübertragung vom Computer zu der Platte ("Computer to Plate"-Technik) meist zu unbefriedigenden Ergebnissen.

Aufgabe der vorliegenden Erfindung ist es, neue Verfahren zu finden, mit deren Hilfe Bildinformationen computergesteuert auf lichtempfindliche Aufzeichnungselemente (A, B), welche der Herstellung von Tief-, Offset-, Hoch- und Flexodruckplatten sowie von Photoresisten dienen, übertragen werden können, ohne daß hierbei die Nachteile des Standes der Technik in Kauf gekommen werden müssen. Außerdem soll diese computergesteuerte Bildinformationsübertragung in einer solchen Art und Weise erfolgen, daß hierbei auf der Oberfläche der betreffenden lichtempfindlichen Aufzeichnungselemente (A, B) eine Bildmaske (C) resultiert, durch welche die lichtempfindlichen Aufzeichnungselemente (A, B) ohne vorherige Entklebung ihrer Oberfläche und ohne die Bildung von Streulicht direkt mit aktinischem Licht belichtet werden können. Außerdem ist es die Aufgabe der vorliegenden Erfindung neue lichtempfindliche Aufzeichnungselemente (A, B, C) zu finden, welche in ihrer Oberfläche eine Bildmaske (C) aufweisen, so daß sie im reprographischen Betrieb vor dem Entwickeln nur noch vollflächig mit aktinischem Licht belichtet werden müssen. Darüber hinaus ist es die Aufgabe der vorliegenden Erfindung, neue Verfahren für die Herstellung von Tief-, Offset-, Hoch- und Flexodruckplatten sowie von Photoresisten zu finden, welche die Nachteile des Standes der Technik nicht mehr länger aufweisen. Nicht zuletzt ist es die Aufgabe der vorliegenden Erfindung, ein neues Gerät zu finden, mit dessen Hilfe die neuen Verfahren besonders schnell und zuverlässig durchgeführt werden können.

Überraschenderweise konnten diese Aufgaben im wesentlichen dadurch gelöst werden, daß man mit Hilfe von Tonern, wie sie in der Elektrophotographie verwendet werden, von Tinten, wie sie für den Tintenstrahldruck verwendet werden, oder von Pigmenten und/oder Pigment/Bindemittel-Mischungen, wie sie für den Thermotransferdruck verwendet werden, eine Bildmaske (C) auf der Oberfläche der lichtempfindlichen Aufzeichnungsschicht (B) eines lichtempfindlichen Aufzeichnungselements (A, B) erzeugt. Im Hinblick auf den Stand der Technik war es überraschend, daß mit Hilfe dieser Toner, Tinten oder Pigmente und/oder Pigment/Bindemittel-Mischungen neue lichtempfindliche Aufzeichnungselemente (A, B, C) hergestellt werden können, welche hervorragende Tief-, Offset-, Hoch-, und Flexodruckplatten sowie Photoresiste liefern.

Demnach handelt es sich bei dem Gegenstand der vorliegenden Erfindung um ein gegenüber

4

ultraviolettem und/oder sichtbarem aktinischem Licht empfindliches Aufzeichnungselement, enthaltend

(A) einen dimensionstabilen Träger,

(B) eine negativ arbeitende oder positiv arbeitende lichtempfindliche Aufzeichnungsschicht (B1) oder (B2) und

(C) eine der Oberfläche der lichtempfindlichen Aufzeichnungsschicht (B1) oder (B2) direkt aufliegende Bildmaske, welche ein reliefartiges Muster aus beschichteten Bereichen (C1) und unbeschichteten Bereichen (C2) darstellt, wobei die beschichteten Bereiche (C1) gegenüber dem jeweils zu verwendenden aktinischen Licht im wesentlichen undurchlässig sind,

wobei das lichtempfindliche Aufzeichnungselement (A, B, C) dadurch gekennzeichnet ist, daß die beschichteten Bereiche (C1) des reliefförmigen Musters bzw. der Bildmaske (C) aus Flüssigkeitströpfchen oder festen Partikeln bestehen, welche auf die Oberfläche der lichtempfindlichen Aufzeichnungsschicht (B1) oder (B2) übertragen worden sind.

Weitere Gegenstände der vorliegenden Erfindung sind Verfahren zur Herstellung des neuen, gegenüber ultraviolettem und/oder sichtbarem aktinischem Licht empfindlichen Aufzeichnungselements (A, B, C) und neue Verfahren zu dessen Weiterverarbeitung zu Tief-, Offset-, Hoch-, und Flexodruckplatten sowie Photoresisten.

Noch ein weiterer Gegenstand der vorliegenden Erfindung ist ein neues Gerät für die Durchführung der vorstehend genannten neuen Herstell- und Weiterverarbeitungsverfahren.

Im folgenden wird der Kürze halber das neue, gegenüber ultraviolettem und/oder sichtbarem aktinischem Licht empfindliche Aufzeichnungselement (A, B, C) der Kürze halber als "erfindungsgemäßes Aufzeichnungselement (A, B, C)" bezeichnet. Dementsprechend werden die neuen Verfahren zur Herstellung und zur Weiterverarbeitung des erfindungsgemäßen Aufzeichnungselements (A, B, C) als "erfindungsgemäße Herstellverfahren" und "erfindungsgemäße Weiterverarbeitungsverfahren" bezeichnet.

Des weiteren wird das neue Gerät zur Durchführung der erfindungsgemäßen Herstell- und Weiterverarbeitungsverfahren als "erfindungsgemäßes Gerät" bezeichnet.

Der für die Erfindung wesentliche Bestandteil des erfindungsgemäßen Aufzeichnungselements (A, B, C) ist die der Oberfläche seiner Lichtempfindlichen Aufzeichnungsschicht (B1) oder (B2) direkt aufliegende Bildmaske (C). Diese Bildmaske (C) ist ein reliefartiges Muster aus beschichteten Bereichen (C1) und unbeschichteten Bereichen (C2). Hierbei sind die beschichteten Bereiche (C1) gegenüber dem jeweils zu verwendenden aktinischen Licht im wesentlichen undurchlässig. Dies bedeutet, daß sie ultraviolettes und/oder sichtbares Licht in einem solchen Ausmaß absorbieren, daß es in der lichtempfindlichen Aufzeichnungsschicht (B1) und (B2) des erfindungsgemäßen Aufzeichnungselements (A, B, C) keine photochemischen Reaktionen mehr auszulösen vermag.

Erfindungsgemäß bestehen die beschichteten Bereiche (C1) des reliefförmigen Musters bzw. der Bildmaske (C) aus Flüssigkeitströpfchen oder festen Partikeln, welche auf die Oberfläche der lichtempfindlichen Aufzeichnungsschicht (B1) oder (B2) übertragen worden sind.

Hierbei haben die Flüssigkeitströpfchen oder festen Partikel eine solche Zusammensetzung, daß sie die vorstehend genannten Bedingung, gegenüber dem jeweils zu verwendenden aktinische Licht im wesentlichen undurchlässig zu sein, erfüllen.

Demnach können die unterschiedlichsten festen Partikel oder Flüssigkeitströpfchen für den Aufbau der beschichteten Bereiche (C1) der Bildmaske (C) verwendet werden, solange sie die vorstehend genannte Eigenschaft haben.

Erfindungsgemäß ist es jedoch von Vorteil Flüssigtonertröpfchen oder Tonerpartikel zu verwenden, wie sie in der Elektrophotographie üblicherweise angewandt werden. Bekanntermaßen handelt es sich bei den Tonern um polymerbeschichtete Pigmentteilchen mit einem mittleren Teilchendurchmesser im Bereich von ca. 0,05 bis 100 $\mu$m, wobei besonders feinteilige Tonerpartikel, welche kolloidal gelöst werden können, erfindungsgemäß besonders bevorzugt verwendet werden. Toner dieser Art gehen beispielsweise aus der EP-A-0 225 547, der DE-A-38 21 199 oder der US-A-4 661 431 hervor.

Für besondere Verwendungszwecke können diese Toner auch noch sehr harte, sehr feinteilige Füllstoffe enthalten. Unter "sehr hart" ist hierbei eine Härte gemäß der modifizierten Mohs-Härteskala von > 7 zu verstehen. Unter feinteilig wird eine mittlere Korngröße der Füllstoffteilchen von 0,5 bis 40 $\mu$m verstanden.

Beispiele besonders gut geeigneter Füllstoffteilchen der genannten Art sind pyrogene Kieselsäure sowie Quarz-, Zirkonia-, Titannitrid-, Wolframcarbid-, Tantalcarbid-, Zirkoniumcarbid, Aluminiumoxid-, Titannitrid-, Zirkoniumborid-, Siliciumcarbid-, Aluminiumborid-, Borcarbid- und Diamantstaub. Von diesen sind pyrogene Kieselsäure sowie Quarz-, Diamant-, Siliciumcarbid- und Wolframcarbidstaub ganz besonders gut geeignet.

Erfindungsgemäß ist es außerdem von Vorteil, die Flüssigkeitströpfchen oder die festen Partikel aus Tinten zu erzeugen, wie sie im Tintenstrahldruck verwendet werden. Bei diesen Tinten kann es sich um Flüssigtinten handeln, welche aus Komponenten bestehen, die bei Raumtemperatur flüssig sind. Die Tinten können aber auch feste Partikel in einer Flüssigkeit gelöst oder dispergiert enthalten oder sie können geschmolzene Tröpfchen auf Kunststoffbasis sein.

Sowohl Tinten auf der Basis von Flüssigkeiten als auch geschmolzene Tinten sind üblich und bekannt sowie im Handel erhältlich und gehen beispielsweise aus dem Artikel "INKJET, heiße Tinte für schnellen Drucker", in Der Polygraph, Heft 14-89, Seiten 1151 und 1152, hervor. Weitere Tintenzusammensetzungen sind aus der DE-A-38 26 734, der DE-A-38 25 007, der DE-A-37 15 643, der DE-A-37 15 630, der DE-A-33 20 373, der DE-A-31 05 525 oder der DE-A-31 06 208 bekannt.

Erfindungsgemäß ist es weiterhin von Vorteil, als Flüssigkeitströpfchen oder als feste Partikel aufgeschmolzene oder aufgedampfte, flüssige oder wiedererstarrte Pigmente oder Pigment/Bindemittel-Mischungen zu verwenden, wie sie im Thermotransferdruck Verwendung finden. Beispiele geeigneter Pigmente oder Pigment/Bindemittel-Mischungen sind beispielsweise aus der DE-A-35 07 418 bekannt.

Weitere Beispiele geeigneter Pigment/Bindemittel-Mischungen bzw. geschmolzener Tinten auf Kunststoffbasis, welche sich sowohl für den Thermotransferdruck als auch für den Tintenstrahldruck verwenden lassen, sind Mischungen aus üblichen und bekannten, im Handel erhältlichen Schwarzpigmenten wie Ruß oder Negropac® und Bindemitteln wie Polyvinylalkohol, Styrol/Maleinsäurehalbester-Copolymerisate oder Methylmethacrylat/Methacrylsäure-Copolymerisate.

Erfindungsgemäß werden Flüssigkeitströpfchen oder feste Partikel auf der Basis von Tonern und von Tinten ganz besonders bevorzugt verwendet.

Erfindungsgemäß liegen die Flüssigkeitströpfchen oder die festen Partikel der Oberfläche der lichtempfindlichen Aufzeichnungsschicht (B1) oder (B2) des erfindungsgemäßen Aufzeichnungselements (A, B, C) direkt auf. Hierbei können insbesondere die festen Partikel mit dessen Oberfläche und/oder mit sich selbst verklebt, verschmolzen und/oder chemisch verknüpft sein. Hierbei kann die chemische Verknüpfung durch Umsetzen der festen Partikel mit geeigneten Reagenzien chemisch, durch Erhitzen thermochemisch und/oder durch Belichten mit aktinischem Licht photochemisch bewerkstelligt worden sein. Außerdem können die festen Partikel zur Steigerung ihrer Undurchlässigkeit gegenüber aktinischem Licht stark absorbierende Substanzen wie Ruß, Mangandioxid, Farbstoffe oder Metallpartikel enthalten, wobei sich die Auswahl dieser lichtabsorbierenden Stoffe vor allem nach der Wellenlänge des aktinischen Lichts richtet und deshalb vom Fachmann sehr leicht getroffen werden kann.

Der weitere wesentliche Bestandteil des erfindungsgemäßen Aufzeichnungselements (A, B, C) ist seine lichtempfindliche Aufzeichnungsschicht (B). Diese kann entweder negativ arbeitend (B1) oder positiv arbeitend (B2) sein.

Bekanntermaßen tritt bei einer negativ arbeitenden lichtempfindlichen Aufzeichnungsschicht (B1) bei der Belichtung mit aktinischem Licht eine Löslichkeitsdifferenzierung zwischen den belichteten und unbelichteten Bereichen in der Weise ein, daß die unbelichteten Bereiche mit einem geeigneten, in seinem Lösevermögen auf die stoffliche Zusammensetzung der betreffenden lichtempfindlichen Aufzeichnungsschicht (B1) abgestimmten Entwicklerlösungsmittel ausgewaschen werden können, wogegen die belichteten Bereiche hierin unlöslich sind.

Demgegenüber tritt bei einer positiv arbeitenden lichtempfindlichen Aufzeichnungsschicht (B2) bei der bildmäßigen Belichtung mit aktinischem Licht eine Löslichkeitsdifferenzierung zwischen den belichteten und unbelichteten Bereichen in der Weise ein, daß die belichteten Bereiche mit einem geeigneten, in seinem Lösevermögen auf die stoffliche Zusammensetzung der betreffenden lichtempfindlichen Aufzeichnungsschicht (B2) abgestimmten Entwicklerlösungsmittel ausgewaschen werden können, wogegen die unbelichteten Bereiche hierin unlöslich sind.

Dabei kann es sich bei den negativ arbeitenden lichtempfindlichen Aufzeichnungsschichten (B1) um die üblichen und bekannten photopolymerisierbaren oder photovernetzbaren Schichten handeln.

Bekanntermaßen enthalten die photopolymerisierbaren lichtempfindlichen Aufzeichnungsschichten (B1) mindestens ein Bindemittel, mindestens ein mit diesem Bindemittel verträgliches, photopolymerisierbares olefinisch ungesättigtes Monomeres und mindestens einen Photopolymerisationsinitiator.

Beispiele geeigneter polymerer Bindemittel zur Verwendung in diesen bekannten negativ arbeitenden photopolymerisierbaren lichtempfindlichen Aufzeichnungsschichten (B1) sind Copolymerisate des Ethylens mit (Meth)Acrylsäure und Vinylestern, Vinylethern, (Meth)Acrylsäureestern und/oder (Meth)- Acrylsäureamiden; maleinierte Alkadienpolymerisate; durch Maleinierung und Teilveresterung oder Teilamidierung polymeranalog modifizierte Alkadienpolymerisate; Copolymerisate von Alkadienen mit $\alpha$, $\beta$-olefinisch ungesättigten Carbonsäuren; carboxylgruppenhaltige Alkadien-Acrylnitril-Copolymerisate; partiell oder nahezu vollständig hydrolysierte Poly(vinylalkoholalkancarbonsäureester); partiell oder nahezu vollständig hydrolysierte Vinylalkoholalkancarbonsäureester-Alkylenoxid-Pfropfmischpolymerisate; Polyalkadiene; Alkadien-Acrylnitril-Copolymerisate; Vinylaromat-Alkadien-Copolymerisate; Vinylaromat-Alkadien-Blockmischpolymerisate; Butylkautschuke; Acrylatkautschuke; Polychloroprene; Fluorkautschuke; Silikonkautschuke; Polysulfidkautschuke; Ethylen-Propylen-Alkadien-Copolymerisate; chlorsulfonierte Polyethylene sowie lineare Homo- und Copolyamide.

Beispiele für geeignete, mit den Bindemitteln verträgliche, photopolymerisierbare, olefinisch ungesättigte Monomere sind Ester der Acrylsäure und der Methacrylsäure; Styrol und dessen Derivate; Ester der Fumarsäure und der Maleinsäure; Vinylester; Vinylether; Acryl- und Methacrylamide sowie Allylverbindungen. Hierbei sind diejenigen Monomeren besonders gut geeignet, welche einen Siedepunkt von über 100°C bei Atmosphärendruck und ein Molekulargewicht von bis zu 3000, insbesondere von bis zu 2000, aufweisen.

Beispiele geeigneter Photopolymerisationsinitiatoren zur Verwendung in negativ arbeitenden photopolymerisierbaren lichtempfindlichen Aufzeichnungsschichten (B1) sind Benzoin oder Benzoinderivate; symmetrisch oder unsymmetrisch substituierte Benzilacetale; Acylarylphosphinoxide und -phosphinsäureester; substituierte und unsubstituierte Chinone sowie Trihalomethylgruppen enthaltende Verbindungen.

Bekanntermaßen enthalten die negativ arbeitenden photovernetzbaren lichtempfindlichen Aufzeichnungsschichten (B1) entweder

- ein hydrophiles Bindemittel und ein lichtempfindliches Metallsalz; ein hydrophiles Bindemittel und ein Tetrazoniumsalz einer Diaminoverbindung wie p-Aminodiphenylamin, Benzidin, Diamidin oder Toluidin;
- ein Diazoharz, welches man im wesentlichen aus Formaldehyd und einem Diphenylamin-diazoniumsalz hergestellt hat;
- ein hydrophiles oder ein alkohollösliches Bindemittel und eine Azidoverbindung;
- einen Kautschuk oder sonstige in organischen Lösungsmittel lösliche Bindemittel und eine Azidoverbindung;
- eine Verbindung, welche beim Bestrahlen mit aktinischem Licht dimerisiert, wie Polyvinylcinnamat; oder
- ein hydrophiles Bindemittel und ein Diazoharz, welches man im wesentlichen aus Formaldehyd und einem Diphenylamin-diazoniumsalz hergestellt hat.

Demgegenüber enthalten die positiv arbeitenden lichtempfindlichen Aufzeichnungsschichten (B2) bekanntermaßen entweder

- ein alkalilösliches Bindemittel und eine Chinondiazidoverbindung wie Naphtochinon-1,2-diazidosulfonatester;
- eine Verbindung, welche bei der Belichtung Säure abspaltet, eine monomere oder polymere Verbindung, welche mindestens eine durch Säure abspaltbare C-O-C-Gruppe, wie etwa eine o-Carbonsäureestergruppe oder eine Carbonsäureamidacetalgruppe, aufweist, und gegebenenfalls ein Bindemittel; oder
- eine Verbindung mit mindestens zwei aromatischen und/oder heteroaromatischen o-Nitrocarbinolestergruppierungen, eine vernetzend wirkende Verbindung mit mindestens zwei reaktiven Gruppen, welche beim Erhitzen mit Carboxylgruppen zu reagieren vermögen, und einen diese Reaktion beschleunigenden Katalysator, wie etwa Iodonium-, Sulfoxonium- oder Pyrryliumsalze.

Die Entscheidung, welche lichtempfindliche Aufzeichnungsschicht (B1) oder (B2) in welcher Dicke für ein erfindungsgemäßes Aufzeichnungselement (A, B, C) verwendet werden soll, richtet sich in der Hauptsache nach dem Verwendungszweck des betreffenden erfindungsgemäßen Aufzeichnungselements (A, B, C), d.h. danach, ob es für die Herstellung einer Tief-, Offset-, Hoch- oder Flexodruckplatte oder eines Photoresists verwendet werden soll. Die für den jeweiligen Verwendungszweck besonders vorteilhaften stofflichen Zusammensetzungen der lichtempfindlichen Aufzeichnungsschichten (B1) oder (B2) sowie die hierbei verwendeten Dickenbereiche sind üblich und bekannt und dem Fachmann geläufig.

Der dritte wesentliche Bestandteil des erfindungsgemäßen Aufzeichnungselements (A, B, C) ist der dimensionsstabile Träger (A). Hierbei kann die lichtempfindliche Aufzeichnungsschicht (B1) oder (B2) mit diesem dimensionsstabilen Träger (A) haftfest oder leicht ablösbar verbunden sein. Der dimensionsstabile Träger (A) wiederum kann mit einer weichelastischen Unterschicht unterlegt sein. Ferner kann eine haftfeste Verbindung zwischen dem Träger (A) und der lichtempfindlichen Aufzeichnungsschicht (B1) oder (B2) mit Hilfe einer Haftschicht erreicht werden. Sofern der dimensionsstabile Träger (A) mit der lichtempfindlichen Aufzeichnungsschicht (B1) oder (B2) leicht ablösbar verbunden ist, wird er auch als temporärer Schichtträger (A) bezeichnet.

Als dimensionsstabile Träger (A) können Platten, Folien oder konische oder zylindrische Röhren (Sleeves) aus Metallen, wie Stahl, Aluminium, Kupfer oder Nickel oder aus Kunststoffen wie Polyethylenterephthalat, Polybutylenterephthalat, Polyamid oder Polycarbonat verwendet werden. Daneben kommen noch Gewebe und Vliese wie Glasfasergewebe oder Verbundmaterialien aus Glasfasern und Kunststoffen wie Polyethylenterephthalat in Betracht. Außerdem kommen als dimensionsstabile Träger (A) auch Platten in Betracht, wie sie üblicherweise bei der Herstellung von Leiterplatten verwendet werden.

In dem erfindungsgemäßen Aufzeichnungselement (A, B, C) kann die Oberfläche der lichtempfindlichen Aufzeichnungsschicht (B1) oder (B2) klebfrei sein. Erfindungsgemäß ist es indes von Vorteil, wenn sie leicht klebrig ist.

Das erfindungsgemäße Aufzeichnungselement (A, B, C) ist ein verkaufsfertiges Produkt und kann ohne Probleme in einer nicht verformbaren, lichtundurchlässigen Verpackung versandt werden.

Das erfindungsgemäße Aufzeichnungselement (A, B, C) kann nach beliebigen Methoden erzeugt werden; vorteilhafterweise wird es nach dem erfindungsgemäßen Verfahren hergestellt.

Das erfindungsgemäße Verfahren geht aus von der Herstellung der lichtempfindlichen Aufzeichnungsschicht (B1) oder (B2). Dies geschieht in üblicher und bekannter Weise durch das Mischen der Komponenten der lichtempfindlichen Aufzeichnungsschicht (B1) oder (B2) mittels der üblichen Knet-, Misch- und Lösungstechniken und durch Formen der hierbei resultierenden Gemische (B1) oder (B2) zu einer flächenförmigen lichtempfindlichen Aufzeichnungsschicht (B1) oder (B2) mittels Gießen aus Lösung, Heißpressen, Kalandrieren oder Extrudieren, wobei man diese Verfahrensschritte auch in geeigneter Weise miteinander kombinieren kann.

Gleichzeitig mit ihrer Herstellung oder unmittelbar danach wird die lichtempfindliche Aufzeichnungsschicht (B1) oder (B2) mit dem dimensionsstabilen Träger (A) gegebenenfalls unter Mitverwendung einer Haftschicht und einer weichelastischen Unterschicht verbunden. Selbstverständlich können diese Arbeitsgänge in üblichen und bekannten, kontinuierlich oder diskontinuierlich arbeitenden Anlagen hintereinander oder gleichzeitig ausgeführt werden. In allen Fällen kann die lichtempfindliche Aufzeichnungsschicht (B1) oder (B2) aus Teilschichten (B1) oder (B2) von gleicher, in etwa gleicher oder unterschiedlicher stofflicher Zusammensetzung aufgebaut werden, wie dies beispielsweise in der EP-A-0 084 851 oder der DE-A-29 42 183 (US-A-4 320 188) beschrieben wird.

In erfindungsgemäßer Verfahrensweise wird hiernach eine Bildmaske (C) auf der Oberfläche der lichtempfindlichen Aufzeichnungsschicht (B1) oder (B2) des lichtempfindlichen Aufzeichnungselements (A, B) erzeugt, indem man Flüssigkeitströpfchen oder feste, geschmolzene oder in Flüssigkeiten dispergierte oder gelöste Partikel bildmäßig auf der betreffenden Oberfläche aufträgt, wonach man vorteilhafterweise die in Flüssigkeiten dispergierten oder gelösten Partikeln trocknen und die geschmolzenen Partikeln erstarren läßt.

Zwar können bei dem erfindungsgemäßen Herstellverfahren beliebige geeignete Flüssigkeitströpfchen oder Partikel verwendet werden, indes ist es erfindungsgemäß von Vorteil, hierbei Toner, wie sie in der Elektrophotographie angewandt werden, Tinten, wie sie in Tintenstrahldruckern angewandt werden, und Pigmente und/oder Pigment/Bindemittel-Mischungen, wie sie im Thermotransferdruck verwendet werden, anzuwenden. Beispiele geeigneter Toner, Tinten, Pigmente und Pigment/Bindemittel-Mischungen sind die vorstehend beschriebenen.

An und für sich können diese Flüssigkeitströpfchen oder Partikel nach beliebigen Methoden bildmäßig auf die Oberfläche der lichtempfindlichen Aufzeichnungsschicht (B1) oder (B2) des lichtempfindlichen Aufzeichnungselements (A, B) aufgetragen werden. Indes ist es für das Endprodukt des erfindungsgemäßen Herstellverfahrens, das erfindungsgemäße Aufzeichnungselement (A, B, C), von besonderem Vorteil, die Toner dadurch aufzutragen, daß man zunächst in an sich bekannter Weise auf der Oberfläche eines an sich bekannten elektrophotographischen Aufzeichnungselements (D) durch Aufladen mit einer Hochspannungsentladungskorona, bildmäßiges Belichten mit aktinischem Licht und Betonern ein Tonerbild erzeugt, welches man dann direkt auf die Oberfläche der lichtempfindlichen Aufzeichnungsschicht (B1) oder (B2) des lichtempfindlichen Aufzeichnungselements (A, B) überträgt.

Für diese vorteilhafte Variante des erfindungsgemäßen Herstellverfahrens kann ein flächenförmiges elektrophotographisches Aufzeichnungselement (D) verwendet werden. Das hierauf erzeugte Tonerbild kann dann entweder stempelartig auf die Oberfläche der lichtempfindlichen Aufzeichnungsschicht (B1) oder (B2) eines flächenförmigen lichtempfindlichen Aufzeichnungselements (A, B) übertragen oder von der Oberfläche der lichtempfindlichen Aufzeichnungsschicht (B1) oder (B2) eines über das Tonerbild hinweggerollten zylinderförmigen lichtempfindlichen Aufzeichnungselements (A, B) aufgenommen werden.

In einer anderen besonders vorteilhaften Variante des erfindungsgemäßen Herstellverfahrens wird ein zylinderförmiges elektrophotographisches Aufzeichnungselement (D) verwendet. Das hierauf erzeugte Tonerbild kann entweder durch Aufwalzen auf die Oberfläche der lichtempfindlichen Aufzeichnungsschicht (B1) oder (B2) eines flächenförmigen lichtempfindlichen Aufzeichnungselements (A, B) oder auf die Oberfläche der lichtempfindlichen Aufzeichnungsschicht (B1) oder (B2) eines zylinderförmigen lichtempfindlichen Aufzeichnungselements (A, B) übertragen werden, indem man das zylinderförmige elektrophotographische Aufzeichnungselement (D) und das zylinderförmige lichtempfindliche Aufzeichnungselement (A, B) in der Art eines Kalanders gegeneinander dreht.

Hierbei ist das erfindungsgemäße Herstellverfahren, bei welchem ein zylinderförmiges elektrophotographisches Aufzeichnungselement (D) und ein zylinderförmiges lichtempfindliches Aufzeichnungselement (A, B) verwendet werden, besonders hervorzuheben, weil es die Herstellung nahtloser Endlosdruckzylinder für den endlosen Tief-, Offset-, Hoch- und Flexodruck in besonders eleganter und einfacher Weise gestattet.

Für alle vorstehend genannten Varianten des erfindungsgemäßen Herstellverfahrens ist es außerdem vorteilhaft, für die bildmäßige Belichtung des elektrostatisch aufgeladenen elektrophotographischen Aufzeichnungselements (D) eine computergesteuerte Laserlichtquelle zu verwenden.

Geeignete flächenförmige und zylinderförmige elektrophotographische Aufzeichnungselemente (D) und geeignete Laserlichtquellen sind vom Photokopiersektor oder aus den Patentschriften EP-A-0 131 215, EP-B-0 031 481, EP-A-0 150 419, EP-A-0 162 216, EP-A-0 156 308, EP-A-0 131 292, EP-A-0 152 889, EP-A-0 198 488, EP-A-0 289 056, EP-A-0 326 132, EP-A-0 326 169 oder DE-A-34 14 791 bekannt.

Eine weitere vorteilhafte Variante des erfindungsgemäßen Herstellverfahrens beruht darauf, daß man hierbei die Tinten, mittels computergesteuerter Tintenstrahldrucker auf die Oberfläche der lichtempfindlichen Aufzeichnungsschicht (B1) oder (B2) eines lichtempfindlichen Aufzeichnungselements (A, B) überträgt. Beispiele geeigneter Tinten und geeigneter computergesteuerter Tintenstrahldrucker sind aus dem Artikel "INKJET, heiße Tinte für schnellen Drucken", in Der Polygraph, Band 14 (1989), Seiten 1151 und 1152, dem Artikel von Oliver Bruns, "Proofs aus digitalem Datenbestand: der Tintenstrahldrucker Iris 3024 am Response-System und Scitex", in Deutscher Drucker, Nr. 36/9.11.89, Seiten W10 und W11, oder der Firmenschrift von Hewlett-Packard, "Professional Printer DeskJet PLUS, Owner's Manual", März 1989, bekannt.

Bei noch einer weiteren vorteilhaften Verfahrensvariante werden Pigmente oder Pigment/Bindemittel-Mischungen für die Erzeugung der beschichteten Bereiche (C1) der Bildmaske (C) verwendet. Hierbei ist es von besonderem Vorteil, die Pigmente und/oder die Pigment/Bindemittel-Mischungen von einer Folie aus, welche eine Pigment- oder eine Pigment/Bindemittel-Schicht enthält, auf die Oberfläche der lichtempfindlichen Aufzeichnungsschicht (B1) oder (B2) des lichtempfindlichen Aufzeichnungselements (A, B) zu übertragen.

Dies wird in ganz besonders vorteilhafter Weise dadurch bewerkstellig, daß man die betreffende Folie von ihrer der Pigment- oder Pigment/Bindemittel-Schicht abgewandten Seite her mittels eines computergesteuerten Thermokopfes oder mittels einer computergesteuerten Laserlichtquelle erwärmt.

Für all die vorstehend genannten Varianten des erfindungsgemäßen Herstellverfahrens ist es von ganz besonderem Vorteil, wenn die Oberfläche der lichtempfindlichen Aufzeichnungsschicht (B1) oder (B2) des bei den erfindungsgemäßen Herstellverfahren verwendeten Aufzeichnungselements (A, B) klebrig ist.

Das erfindungsgemäße Herstellverfahren weist ganz besondere überraschende Vorteile auf.

Zum einen ermöglicht das erfindungsgemäße Herstellverfahren die Übertragung digitaler Bildinformationen auf lichtempfindliche Aufzeichnungselemente (A, B), zum anderen ermöglicht es die einfache und sichere Herstellung der erfindungsgemäßen lichtempfindlichen Aufzeichnungselemente (A, B, C). Daneben ist das erfindungsgemäße Herstellverfahren geradezu außerordentlich variabel, denn es gestattet nicht nur die Herstellung flächenförmiger erfindungsgemäßer Aufzeichnungselemente (A, B, C) in beliebigen Formaten, sondern auch die ganz besonders einfache und rationelle Herstellung von zylinderförmigen erfindungsgemäßen Aufzeichnungselementen (A, B, C), welche sich ansonsten nur schlecht herstellen lassen. Des weiteren gestattet das erfindungsgemäße Herstellverfahren die zentrale und daher rationelle und wirtschaftliche Herstellung flächenförmiger und zylinderförmiger erfindungsgemäßer Aufzeichnungselemente (A, B, C) nach den Wünschen von Druckereien in einem Herstellbetrieb. Hierbei brauchen die Druckereien die zu vervielfältigende Bildinformation nur noch digital dem zentralen Herstellbetrieb zu übermitteln, wonach sie von diesem die nach dem erfindungsgemäßen Herstellverfahren hergestellten flächenförmigen oder zylinderförmigen erfindungsgemäßen Aufzeichnungselemente (A, B, C) zur weiteren Verarbeitung erhalten. Indes ist es auch möglich, daß der zentrale Herstellbetrieb die betreffenden flächenförmigen oder erfindungsgemäßen Aufzeichnungselemente (A, B, C) selbst weiterverarbeitet und die resultierenden Tief-, Offset-, Hoch- und Flexodruckplatten den Druckereien zuleitet. Diese Vorgehensweise kommt selbstverständlich auch für die Herstellung und die Weiterverarbeitung von Photoresisten in Betracht, wie sie für die Herstellung von Leiterplatten angewandt werden.

Unabhängig davon, ob das erfindungsgemäße Herstellverfahren in einem zentralen Herstellbetrieb, einer Druckerei oder einem Leiterplattenhersteller ausgeübt wird, tritt ein weiterer besonderer Vorteil zu Tage, welcher darin liegt, daß das spätere Druck- oder Leiterbahnenbild bereits unmittelbar nach der Herstellung der erfindungsgemäßen Aufzeichnungselemente (A, B, C) kontrastreich zu erkennen ist. Sollte dieses Druck- oder Leiterbahnenbild wider Erwarten noch korrigiert werden müssen oder sollten auf Wunsch des Druckers oder des Leiterplattenherstellers noch kurzfristig Änderungen hieran vorgenommen werden, kann all dies noch jederzeit in einfacher Weise erfolgen: es ist nur notwendig, die Bildmaske (C) mit einem geeigneten Lösungsmittel, welches die lichtempfindliche Aufzeichnungsschicht (B) nicht angreift, wegzuwaschen und hiernach die korrigierte oder die geänderte Bildmaske (C) in erfindungsgemäßen Verfahrensweise erneut aufzutragen.

Die erfindungsgemäßen Aufzeichnungselemente (A, B, C), insbesondere aber die nach dem erfindungsgemäßen Herstellverfahren erhaltenen, können in beliebiger Weise weiterverarbeitet werden. Erfindungsgemäß ist es indes von Vorteil, hierbei das erfindungsgemäße Weiterverarbeitungsverfahren anzuwenden.

Das erfindungsgemäße Weiterverarbeitungsverfahren dient der Herstellung druckfertiger Tief-, Offset-, Hoch- und Flexodruckplatten sowie der Herstellung von Photoresisten. Es geht aus von einem erfindungsgemäßen Aufzeichnungselement (A, B, C), welches für das jeweilige drucktechnische Gebiet oder das Photoresistgebiet geeignet ist. Dieses erfindungsgemäße Aufzeichnungselement (A, B, C) wird in erfindungsgemäßer Verfahrensweise direkt vollflächig mit ultraviolettem und/oder sichtbarem aktinischem Licht belichtet. Da die beschichteten Bereiche (C1) der Bildmasken (C) des erfindungsgemäßen Aufzeichnungselements (A, B, C) gegenüber dem jeweils verwendeten aktinischen Licht im wesentlichen undurchlässig sind, treten in denjenigen Bereichen der lichtempfindlichen Aufzeichnungsschicht (B1) oder (B2), die von den beschichteten Bereichen (C1) bedeckt sind, keine photochemischen Veränderungen ein. Dagegen werden diejenigen Bereiche, welche nicht durch die Bildmaske (C) bedeckt sind (unbeschichtete Bereiche C2), durch die einfallende aktinische Strahlung photochemisch verändert, so daß sie nach der Belichtung andere Löslichkeitseigenschaften aufweisen als die unbelichteten Bereiche, was auch als Löslichkeitsdifferenzierung bezeichnet wird.

Je nachdem ob das erfindungsgemäße Aufzeichnungselement (A, B, C) eine positiv arbeitende (B1) oder eine negativ arbeitende (B2) lichtempfindliche Aufzeichnungsschicht aufweist, ergeben sich vorteilhafte Varianten des erfindungsgemäßen Weiterverarbeitungsverfahrens.

Wird das erfindungsgemäße Weiterverarbeitungsverfahren bei erfindungsgemäßen Aufzeichnungselementen (A, B, C) angewandt, welche eine positiv arbeitende lichtempfindliche Aufzeichnungsschicht (B2) enthalten, werden aufgrund der stofflichen Zusammensetzung der lichtempfindlichen Aufzeichnungsschicht (B2) die belichteten Bereiche in den Entwicklerlösungsmitteln löslich oder dispergierbar und können daher ausgewaschen werden. Dagegen bleiben die nicht belichteten Bereiche der belichteten Aufzeichnungsschicht (B2) in dem betreffenden Entwicklerlösungsmittel unlöslich, so daß eine positive Kopie der ursprünglichen, digital übertragenen Bildinformation resultiert. Hierbei ist es nun von ganz besonderem Vorteil, wenn die beschichteten Bereiche (C1) der Bildmaske (C) gleichfalls in dem betreffenden Entwicklerlösungsmittel unlöslich sind und beim Auswaschen der belichteten Bereiche der Aufzeichnungsschicht (B2) nicht weggewaschen werden, sondern auch der Oberfläche der entwickelten Aufzeichnungsschicht (B2) zurückbleiben.

Das Entwicklerlösungsmittel für die belichtete Aufzeichnungsschicht (B2) kann vom Fachmann in einfacher Weise aufgrund der stofflichen Eigenschaften der betreffenden Aufzeichnungsschicht (B2) ausgewählt werden. So wird er für unpolare belichtete Aufzeichnungsschichten (B2) organische Lösungsmittel wählen, wogegen er für polare oder stark polare belichtete Aufzeichnungsschichten (B2) polare oder wäßrige Lösungsmittel nehmen wird.

Für die in Rede stehende Variante des erfindungsgemäßen Weiterverarbeitungsverfahrens ist es außerdem von ganz besonderem Vorteil, wenn hierbei entweder die vorstehend beschriebenen Toner, wie sie in der Elektrophotographie verwendet werden, oder die vorstehend beschriebenen Pigmente und/oder Pigment/Bindemittel-Mischungen, wie sie im Thermotransferdruck verwendet werden, Anwendung finden. Weitere Vorteile ergeben sich, wenn die festen Partikel verwendet werden, welche die vorstehend genannten sehr harten, sehr feinteiligen Füllstoffteilchen enthalten. Außerdem ist es für das erfindungsgemäße Weiterverarbeitungsverfahren besonders vorteilhaft, wenn die durch das erfindungsgemäße Herstellverfahren aufgebrachten beschichteten Bereiche (C1) der Bildmaske (C) bei der vollflächigen Belichtung mit aktinischem Licht photochemisch vernetzt werden. Des weiteren können diese beschichteten Bereiche (C1) der Bildmaske (C) nach dem Entwickeln des betreffenden belichteten erfindungsgemäßen Aufzeichnungselements (A, B2, C) noch thermisch vernetzt und/oder in die Oberfläche der entwickelten Aufzeichnungsschicht (B2) eingebrannt werden. Dabei kann die thermische Vernetzung und/oder das Einbrennen zusätzlich zu der photochemischen Vernetzung oder anstelle von dieser erfolgen.

Zum Zwecke der photochemischen und/oder thermischen Vernetzung und/oder dem Einbrennen können die beschichteten Bereiche (C1) der Bildmaske (C) bzw. die ursprünglich zu ihrer Herstellung verwendeten Toner oder Pigmente oder Pigment/Bindemittel-Mischungen geeignete funktionelle Gruppen und/oder geeignete Vernetzungshilfsmittel wie Photopolymerisationsinitiatoren, Initiatoren der thermischen radikalischen Polymerisation, organische Silane und/oder Epoxiharze enthalten. Funktionelle Gruppen und Vernetzungshilfsmittel dieser Art sind üblich und bekannt. Ihre Auswahl richtet sich in erster Linie nach dem Verwendungszweck, welcher die aus dem erfindungsgemäßen Aufzeichnungselement (A, B2, C) hergestellte Druckplatte oder der aus dem erfindungsgemäßen Aufzeichnungselement (A, B2, C) hergestellte Photoresist haben soll, und kann daher vom Fachmann in einfacher Weise getroffen werden.

Der besondere Vorteil dieser Variante des erfindungsgemäßen Weiterverarbeitungsverfahrens liegt darin, daß hierbei Tief-, Offset-, Hoch- und Flexodruckplatten sowie Photoresiste resultieren, welche außer einer ausgesprochen detailgetreuen Wiedergabe der ursprünglichen digitalen Bildinformation auch noch eine besonders abriebfeste Oberfläche haben.

Hinzu kommt noch, daß diese Oberfläche klebfrei ist. Außerdem kann sie in ihren anderen wichtigen anwendungstechnischen Eigenschaften - etwa in ihren für das Druckverhalten so wichtigen Farbübertragungseigenschaften - zu Zwecken der Optimierung und der Anpassung an vorgegebene technische Rahmenbedingungen mit Hilfe der in Rede stehenden Verfahrensvariante in vorteilhafter Weise breit variiert werden.

Deswegen haben auch die aus den erfindungsgemäßen Aufzeichnungselementen (A, B2, C) mit Hilfe der vorstehend beschriebenen Variante des erfindungsgemäßen Weiterverarbeitungsverfahrens hergestellten Druckplatten eine besonders lange Lebensdauer unter Druckbedingungen und liefern exzellente Druckerzeugnisse in besonders hoher Auflage. Die in entsprechender Weise hergestellten Photoresiste haben eine ausgesprochen niedrige Ausschußrate, was die Herstellung von Leiterplatten erheblich verbilligt.

In einer weiteren vorteilhaften Variante des erfindungsgemäßen Weiterverarbeitungsverfahrens wird ein erfindungsgemäßes Aufzeichnungselement (A, B1, C) verwendet, welches eine negativ arbeitende lichtempfindliche Aufzeichnungsschicht (B1) enthält. Auch diese Variante geht aus von dem vollflächigen Belichten des betreffenden erfindungsgemäßen Aufzeichnungselements (A, B1, C) mit ultraviolettem und/oder sichtbarem aktinischem Licht. Hierdurch wird in den Bereichen der lichtempfindlichen Aufzeichnungsschicht (B1), welche nicht von den beschichteten Bereichen (C1) der Bildmaske (C) bedeckt sind, die Photopolymerisation oder die Photovernetzung ausgelöst, wodurch die belichteten Bereiche in Entwicklerlösungsmitteln unlöslich werden. Dagegen bleiben die unter den beschichteten Bereichen (C1) befindlichen Bereiche der lichtempfindlichen Aufzeichnungsschicht (B1) wegen der optischen Abschirmwirkung der Bereiche (C1) in den betreffenden Entwicklerlösungsmitteln weiterhin löslich oder dispergierbar und werden deshalb bei der nachfolgenden Entwicklung des belichteten erfindungsgemäßen Aufzeichnungselements zusammen mit den darüberliegenden beschichteten Bereichen (C1) der Bildmaske (C) ausgewaschen. Hierbei ist es von besonderem Vorteil, wenn die beschichteten Bereiche (C1) gleichfalls in den Entwicklerlösungsmitteln löslich oder dispergierbar sind, so daß sie problemlos zusammen mit den nicht belichteten Bereichen der Aufzeichnungsschicht (B1) ausgewaschen werden können. Die Auswahl der Entwicklerlösungsmittel für diese Variante des erfindungsgemäßen Weiterverarbeitungsverfahrens kann anhand der gleichen Kriterien getroffen werden, wie sie vorstehend für die andere Variante beschrieben sind.

Bei der hier in Rede stehenden Variante des erfindungsgemäßen Weiterverarbeitungsverfahrens resultieren sowohl flächenförmige als auch zylinderförmige druckfertige Tief-, Offset-, Hoch- und Flexodruckplatten sowie Photoresiste, welche für die Leiterplattenherstellung verwendet werden können. Diese Druckplatten und Photoresiste enthalten in ihrer entwickelten Aufzeichnungsschicht (B1) das Negativ der ursprünglichen, digital übertragenen Bildinformation. Der besondere Vorteil des erfindungsgemäßen Weiterverarbeitungsverfahren manifestiert sich auch hier insbesondere darin, daß die betreffenden Druckplatten und Photoresiste, die ursprüngliche, digital übertragenen Bildinformation besonders detailgetreu als Negativ wiedergeben. Dies hat zur Folge, daß die Druckplatten besonders exzellente Druckerzeugnisse in hoher Auflage liefern und die Photoresiste nur eine sehr geringe Ausschußrate aufweisen.

Einer der wesentlichsten Vorteile der erfindungsgemäßen Aufzeichnungselemente (A, B, C), des erfindungsgemäßen Herstellverfahrens und des erfindungsgemäßen Weiterverarbeitungsverfahrens liegt vor allem darin, daß hierbei lichtempfindliche Aufzeichnungselemente (A, B) verwendet werden können, welche eine klebrige Oberfläche haben. Dagegen kommen bei den allermeisten Verfahren des Standes der Technik lichtempfindliche Aufzeichnungselemente (A, B) mit klebriger Oberfläche für die Herstellung von Druckplatten oder Photoresisten nur eingeschränkt in Betracht.

Das erfindungsgemäße Herstellverfahren kann mit Hilfe beliebiger üblicher und bekannter Geräte durchgeführt werden. Indes ist es von besonderem Vorteil, das erfindungsgemäße Gerät für die Durchführung des erfindungsgemäßen Herstellverfahrens zu verwenden. Das erfindungsgemäße Gerät kann des weiteren so ausgestaltet werden, daß es auch noch für die Durchführung des erfindungsgemäßen Weiterverarbeitungsverfahrens geeignet ist.

Der erste wesentliche Bestandteil des erfindungsgemäßen Gerätes ist ein zylinderförmiges elektrophotographisches Aufzeichnungselement (D), welches einen elektrisch leitenden dimensionsstabilen Träger (D1) und eine organische oder anorganische photoleitende Aufzeichnungsschicht (D2) umfaßt. Beispiele geeigneter zylinderförmiger elektrophotographischer Aufzeichnungselemente (D) sind z.B. vom Photokopiersektor her bekannt.

Die weiteren wesentlichen Bestandteile des erfindungsgemäßen Gerätes sind

- mindestens eine Vorrichtung (E) zum Erzeugen einer Hochspannungsentladungskorona zum elektrostatischen Aufladen des zylinderförmigen elektrophotographischen Aufzeichnungselements (D),
- mindestens eine Vorrichtung (F) für die bildmäßige Belichtung der elektrostatisch aufgeladenen photoleitenden Aufzeichnungsschicht (D2) mit aktinischem Licht,
- mindestens eine Vorrichtung (G) zum Betonern des auf der elektrostatisch aufgeladenen photoleitenden Aufzeichnungsschicht (D2) durch bildmäßiges Belichten erzeugten Ladungsbildes,
- mindestens eine Vorrichtung (H) zum Übertragen des Tonerbildes auf eine andere Oberfläche, und
- mindestens eine Vorrichtung (I) zum kontrollierten Drehen des zylinderförmigen elektrophotographischen Aufzeichnungselements (D).

Diese Komponenten (D) bis (I) und ihr Zusammenwirken sind vom Photokopiersektor her bekannt.

Darüber hinaus umfaßt aber das erfindungsgemäße Gerät noch zumindest eines der zylinderförmigen oder flächenförmigen, gegenüber ultraviolettem und/oder sichtbarem aktinischem Licht empfindlichen Aufzeichnungselemente (A, B), wie sie vorstehend beschrieben worden sind.

Hierbei ist es für das erfindungsgemäße Gerät und seine Funktion wesentlich, daß das zylinderförmige oder flächenförmige lichtempfindliche Aufzeichnungselement (A, B) in direktem Kontakt mit dem zylinderförmigen elektrophotographischen Aufzeichnungselement (D) steht und hiergegen mit abgestimmter relativer Geschwindigkeit bewegt werden kann.

Das erfindungsgemäße Herstellverfahren wird mit dem erfindungsgemäßen Gerät wie folgt durchgeführt: Zunächst wird auf dem sich drehenden zylinderförmigen elektrophotographischen Aufzeichnungselement (D) in üblicher und bekannter Weise ein Tonerbild erzeugt. Dieses Tonerbild wird an der Stelle, an der das betonerte zylinderförmige elektrophotographische Aufzeichnungselement (D) mit dem lichtempfindlichen Aufzeichnungselement (A, B) in Berührung kommt, auf dieses übertragen. Beim Weiterdrehen des zylinderförmigen elektrophotographischen Aufzeichnungselements (D) wird seine Oberfläche von noch anhaftenden Tonerresten befreit, so daß es für einen neuen Abbildungszyklus zur Verfügung steht.

Sowohl für das erfindungsgemäße Gerät als auch das erfindungsgemäße Herstellverfahren ist es besonders vorteilhaft, wenn das Gerät noch mindestens eine Vorrichtung (J) zum Entfernen des nach dem Übertragen gegebenenfalls noch vorhandenen überschüssigen Toners von der Oberfläche des zylinderförmigen elektrophotographischen Aufzeichnungselements (D) und/oder noch mindestens eine Vorrichtung (K) für die kontrollierte Bewegung des zylinderförmigen oder flächenförmigen lichtempfindlichen Aufzeichnungselements (A, B) enthält.

Ganz besonders vorteilhaft ist es, wenn man in dem erfindungsgemäßen Gerät für das erfindungsgemäße Herstellverfahren ein zylinderförmiges lichtempfindliches Aufzeichnungselement (A, B) verwendet, welches gegen das zylinderförmige elektrophotographische Aufzeichnungselement (D) in der Art eines Kalanders gedreht wird. Durch diesen ganz besonders vorteilhaften Aufbau des erfindungsgemäßen Geräts wird eine besonders exakte und rasche Übertragung des Tonerbildes von dem zylinderförmigen elektrophotographischen Aufzeichnungselement auf das zylinderförmige lichtempfindliche Aufzeichnungselement (A, B) bewirkt.

In einer weiteren besonders vorteilhaften Variante des erfindungsgemäßen Gerätes wird das flächenförmige lichtempfindliche Aufzeichnungselement (A, B) in der Form eines endloses Bandes an dem zylinderförmigen elektrophotographischen Aufzeichnungselement (D) vorbeigeführt, welches kontinuierlich sein Tonerbild auf das bandförmige lichtempfindliche Aufzeichnungselement (A, B) überträgt.

Für die Durchführung des erfindungsgemäßen Weiterverarbeitungsverfahrens kann das erfindungsgemäße Gerät außer den vorstehend beschriebenen Bestandteilen (D) bis (K) noch

- mindestens eine Vorrichtung (L) zum vollflächigen Belichten des mit Hilfe des erfindungsgemäßen Gerätes hergestellten erfindungsgemäßen Aufzeichnungselements (A, B, C),
- mindestens eine Vorrichtung (M) zum Auswaschen der belichteten oder unbelichteten Bereiche des vollflächig belichteten erfindungsgemäßen Aufzeichnungselements (A, B, C),
- mindestens eine Vorrichtung (N) zum Trocknen des ausgewaschenen erfindungsgemäßen Aufzeichnungselements (A, B, C) und/oder
- mindestens eine Vorrichtung (O), welche dem Zuführen des lichtempfindlichen Aufzeichnungselements (A, B) zum zylinderförmigen elektrophotographischen Aufzeichnungselements (D) sowie zum Abführen des erfindungsgemäßen Aufzeichnungselements (A, B, C) hiervon dient,

enthalten.

In allen Fällen erweist es sich als besonders vorteilhaft, wenn das erfindungsgemäße Gerät als Vorrichtung (F) eine computergesteuerte Laserlichtquelle enthält.

Auch für das erfindungsgemäße Gerät ist es von ganz besonderem Vorteil, wenn die Oberfläche der lichtempfindlichen Aufzeichnungsschicht (B1) oder (B2) des hierin verwendeten lichtempfindlichen Aufzeichnungselements (A, B) klebrig ist. Wegen dieses nicht zu unterschätzenden Vorteils ist es nicht mehr länger notwendig, die Oberfläche lichtempfindlicher Aufzeichnungselemente (A, B) nach ihrer Herstellung zu entkleben. Aufgrund seiner besonderen Vorteile ist das erfindungsgemäße Gerät vor allem für die Herstellung nahtloser Tief-, Offset-, Hoch- und Flexodruckzylinder für den Endlosdruck geeignet. Darüber hinaus können kontinuierlich flächenförmige erfindungsgemäße Aufzeichnungselemente (A, B, C) sowie deren Weiterverarbeitungsprodukte hergestellt werden, welche dann dem jeweiligen Anwendungszweck gemäß zugeschnitten werden können. Beispielsweise können mit Hilfe des erfindungsgemäßen Gerätes endlose Photoresistbahnen erzeugt werden, die vor ihrer Endverarbeitung visuell kontrolliert und danach auf die gewünschte Größe zugeschnitten werden können. Hierdurch kann die ohnedies schon vorteilhaft niedrige Ausschußrate des erfindungsgemäßen Herstellverfahrens und des erfindungsgemäßen Weiterverarbeitungsverfahrens noch einmal weiter verringert werden. Insgesamt ermöglicht das erfindungsgemäße Gerät die rasche, sichere und exakte Übertragung digitaler Bildinformationen auf eine Vielzahl unterschiedlichster Aufzeichnungselemente (A, B). Das erfindungsgemäße Gerät ist deshalb außerordentlich variabel.

Beispiele und Vergleichsversuche

Beispiele 1 bis 102 mit Vergleichsversuche V1 bis V10

Die Herstellung erfindungsgemäßer Aufzeichnungselemente (A, B, C) und ihre erfindungsgemäße Weiterverarbeitung zu Druckplatten (Beispiele 1 bis 102) im Vergleich mit der nicht erfindungsgemäßen Weiterverarbeitung bekannter Aufzeichnungselemente (A, B) zu Druckplatten (Vergleichsversuche V1 bis V10).

Allgemeine Versuchsvorschrift

Für die Beispiele 1 bis 102 und die Vergleichsversuche V1 bis V10 wurden die in der Tabelle zusammengestellten lichtempfindlichen Aufzeichnungselemente (A, B,)-1 bis (A, B)-10 verwendet. Die Tabelle gibt Auskunft über den Aufbau dieser an sich bekannten lichtempfindlichen Aufzeichnungselemente (A, B), die Dicke, und die stoffliche Zusammensetzung ihrer lichtempfindlichen Aufzeichnungsschichten (B) und deren Abbildungstypes (negativ arbeitend: B1; positiv arbeitend: B2) sowie über das Anwendungsgebiet, für das die aus diesen Aufzeichnungselementen (A, B) hergestellten Druckplatten üblicherweise in Betracht kommen.

Tabelle: Aufbau und Anwendungszweck der verwendeten lichtempfindlichen Aufzeichnungselemente (A, B)

| Aufzeich-nungs-element Nr. (A, B)- | Aufbau: Träger (A): Art und Dicke ($\mu$m) | Aufzeichnungsschicht (B): Zusammensetzung Gew.-% | | Typ und Dicke ($\mu$m) | Anwendungs-zweck (verwendet in Beispiel Nr. und Vergleichs-versuch Nr.) |
|---|---|---|---|---|---|
| 1 | Stahlblech mit Haftschicht (240) | 52,921 | partiell hydrolysiertes Polyvinyl-acetat (Verseifungsgrad: 88 %), verestert mit 3 % Methacrylsäure | B1 (200) | Tiefdruck (1, 11, 21, 31, |
| | | 35,27 | des aliphatischen Epoxiacrylats der Formel | | 41, 51, 61, 71, 81, 92, V1) |

| | | 9,80 | mit Aminosilan behandeltes Quarz-mehl (mit 95 % der Teilchen feiner als 5$\mu$m und 50 % der Teilchen feiner als 2 $\mu$m; verwendet wurde Silbond® 800 AST der Fa. Quarz-werke Frechen) | | |
|---|---|---|---|---|---|
| | | 1,47 | Benzildimethylacetal | | |
| | | 0,49 | Kaliumsalz des N-Nitrosocyclo-hexylhydroxylamins | | |
| | | 0,049 | Safranin T (C.I. 50 240) | | |

EP 0 465 949 A2

Tabelle: Fortsetzung

| Aufzeich-nungs-element Nr. (A, B)- | Aufbau: Träger (A): Art und Dicke ($\mu$m) | Aufzeichnungsschicht (B): Zusammensetzung Gew.-% | Typ und Dicke ($\mu$m) | Anwendungs-zweck (verwendet in Beispiel Nr. und Vergleichs-versuch Nr.) |
|---|---|---|---|---|
| 2 | Träger wie bei (A, B)-1 | Zusammensetzung wie bei (A, B)-1, nur, daß das aliphatische Epoxiacrylat durch die gleiche Menge (35,27) an Dicyclopentadienyldiacrylat ersetzt wurde | B1 (200) | Tiefdruck (2, 12, 22, 32, 42, 52 62, 72, 82, 93, V2) |
| 3 | Träger wie bei (A, B)-1 | Zusammensetzung wie bei (A, B)-1, nur daß das aliphatische Epoxiacrylat durch die gleiche Menge (35,27) des Umsetzungsproduktes von 3,4-Epoxicyclo-hexylmethyl-3',4'-epoxicyclohexan-carboxylat mit Methacrylsäure im molaren Verhältnis von 1 : 2,2 ersetzt wurde | B1 (200) | Tiefdruck (3, 13, 23, 33, 43, 53, 63, 73, 83, 94, V3) |

Tabelle: Fortsetzung

| Aufzeich-nungs-element Nr. (A, B)- | Aufbau: Träger (A): Art und Dicke ($\mu$m) | Aufzeichnungsschicht (B): Zusammensetzung Gew.-% | Typ und Dicke ($\mu$m) | Anwendungs-zweck (verwendet in Beispiel Nr. und Vergleichs-versuch Nr.) |
|---|---|---|---|---|
| 4 | Träger wie bei (A, B)-1 | 58,08 alkohollösliches Mischpolyamid aus etwa gleichen Anteilen Hexamethylendiammonium-adipat, 4,4'-Diammonium-dicyclohexylmethan-adipat und $\varepsilon$-Caprolactam 30,04 des Epoxiacrylats der Formel | B1 (150) | Tiefdruck (4, 14, 24, 34, 44, 54 64, 74, 84, 95, V4) |

10,04 des Quarzmehls gemäß (A, B)-1

1,20 Benzildimethylacetal

0,60 Kaliumsalz des N-Nitrosocyclo-
hexylhydroxylamins

0,04 Safranin T (C.I. 50240)

EP 0 465 949 A2

Tabelle: Fortsetzung

| Aufzeichnungs-element Nr. (A, B)- | Aufbau: Träger (A): Art und Dicke ($\mu$m) | Aufzeichnungsschicht (B): Zusammensetzung Gew.-% | | Typ und Dicke ($\mu$m) | Anwendungs-zweck (verwendet in Beispiel Nr. und Vergleichs-versuch Nr.) |
|---|---|---|---|---|---|
| 5 | Träger wie bei (A, B)-1 | 54,792 | des Mischpolyamids gemäß (A, B)-4 | B1 (500) | Hochdruck (5, 15, 25, |
| | | 22,83 | Penterythrittriglycidylether-triacrylat | | 35, 45, 55 |
| | | 18,264 | Phenylglycidyletheracrylat | | 65, 75, 85, |
| | | 2,74 | Sojalecithin | | 96, V5) |
| | | 1,1 | Benzildimethylacetal | | |
| | | 0,274 | Kaliumsalz des N-Nitrosocyclohexyl-hydroxylamins | | |
| 6 | Polyethylen-terephthalat-folie mit Poly-urethanhaft-lack beschich-tet (125) | 87,592 | Dreiblockkautschuk aus Styrol/Isopren/Styrol-Butadien gemäß EP-A-0 027 612, Beispiel 2 | B1 (2700) | Flexodruck (6, 16, 26, 36, 46, 56, 66, 76, 86, 97, V6) |
| | | 5,000 | Paraffinöl | | |
| | | 5,000 | Hexan-1,6-diol-diacrylat | | |
| | | 1,200 | Benzildimethylacetal | | |
| | | 1,200 | 2,6-Di-tert.-butyl-p-kresol | | |
| | | 0,008 | Solvent Black (C.I. 26 150) | | |

EP 0 465 949 A2

Tabelle: Fortsetzung

| Aufzeich-<br>nungs-<br>element<br>Nr.<br>(A, B)- | Aufbau:<br>Träger (A):<br><br>Art und<br>Dicke ($\mu$m) | Aufzeichnungsschicht (B):<br>Zusammensetzung<br><br><br>Gew.-% | | Typ<br>und<br>Dicke ($\mu$m) | Anwendungs-<br>zweck (verwendet<br>in Beispiel Nr.<br>und Vergleichs-<br>versuch Nr.) |
|---|---|---|---|---|---|
| 7 | Träger wie<br><br>bei (A, B)-6 | 93,596<br><br>5,000<br>0,400<br>1,000<br>0,004 | des Dreiblockkautschuks gemäß<br><br>(A, B)-6<br>Hexan-1,6-diol-diacrylat<br>Benzildimethylacetal<br>2,6-Di-tert.-butyl-p-kresol<br>Solvent Black (C.I. 26 150) | B1<br><br>(2700) | Flexodruck<br><br>(7, 17, 27, 37<br>47, 57, 67,<br>77, 87, 98,<br>V7) |
| 8 | Träger wie bei<br><br>(A, B)-6 | 78<br><br><br><br><br>10<br>6<br>4<br>2 | eines Terpolymers aus<br><br>Ethylen/Propylen/Ethylidennor-<br>bornen (Anteil an Ethylen:<br>50 %; 8 Doppelbindungen je<br>1000 C-Atome)<br>Dioctyladipat<br>Dihydrocyclopentadienylacrylat<br>Isobornylacrylat<br>Benzildimethylacetal | B1<br><br>(2700) | Flexodruck<br><br>(8, 18, 28,<br>38, 48, 58<br>68, 78, 88,<br>99, V8) |

EP 0 465 949 A2

Die lichtempfindlichen Aufzeichnungselemente (A, B)-1 bis (A, B)-10 wurden auf Druckzylinder geeigneter Abmessungen aufgespannt und in dieser Form mit einer Bildmaske (C) aus beschichteten (C1) und unbeschichteten (C2) Bereichen versehen. Hierbei wurden die Elemente (A, B)-6 bis-8 vor dem Aufspannen auf die Druckzylinder während 2 Minuten von ihrer Rückseite her, d.h. durch den Träger (A) hindurch, in üblicher und bekannter Weise vollflächig mit aktinischem Licht vorbelichtet.

Dazu wurde für die Durchführung der Beispiele 1 bis 4, 9 bis 14, 19 bis 24, 29 bis 34, 39 bis 44, 49 bis

**Tabelle: Fortsetzung**

| Aufzeichnungselement Nr. (A, B)- | Aufbau: Träger (A): Art und Dicke (μm) | Aufzeichnungsschicht (B): Zusammensetzung Gew.-% | | Typ und Dicke (μm) | Anwendungszweck (verwendet in Beispiel Nr. und Vergleichsversuch Nr.) |
|---|---|---|---|---|---|
| 9 | Träger wie bei (A, B)-1 | 54 | des Mischpolyamids gemäß (A, B)-4 | B1 (200) | Tiefdruck (9, 19, 29, 39, 49, 59, 69, 79, 89, 100, V9) |
| | | 24 | des Diethers aus 1 Mol Ethylen-glycol und 2 Mol N-Methylol-acrylamid | | |
| | | 2 | Benzildimethylacetal | | |
| | | 20 | des Quarzmehls Silbond® Typ F 600 der Fa. Quarzwerke Frechen | | |
| 10 | Träger wie bei (A, B)-1 | 96,0 | Novolakharz aus Phenol und Formaldehyd | B2 (120) | Tiefdruck (10, 20, 30, 40, 50, 60, 70, 80, 90, 91, 101, 102, V10) |
| | | 1,0 | Viktoriablau (C.I. 44 045) | | |
| | | 0,7 | 2-Trichlormethyl-5-[(2'-benzo-furyl)-vinyl]-1,3,4-oxadiazol | | |
| | | 2,3 | Glutarsäureanhydrid | | |

54, 59 bis 64, 69 bis 74, 79 bis 84, 89 bis 95 sowie 100 bis 102 auf einem Graphikcomputer mit Hilfe eines Graphikprogramms ein für das Tiefdruckgebiet typisches Rasterbild als Testbildvorlage entwickelt und zwecks Übertragung auf die lichtempfindlichen Aufzeichnungselemente (A, B)-1 bis (A, B)-4 sowie (A, B)-9 und (A, B)-10 abgespeichert.

In analoger Weise wurde der bekannte FOGRA Präzisionsmeßstreifen für den Zeitungsdruck PMS-Z für die Durchführung der Beispiele 5, 15, 25, 35, 45, 55, 65, 75, 85 und 96 auf dem Graphikcomputer zur Übertragung auf das lichtempfindliche Aufzeichnungselement (A, B)-5 abgespeichert.

Für die Durchführung der Beispiele 6 bis 8, 16 bis 18, 26 bis 28, 36 bis 38, 46 bis 48, 56 bis 58, 66 bis 68, 76 bis 78, 86 bis 88 sowie 97 bis 99 wurde mit Hilfe des Graphikprogramms eine für das Flexodruckgebiet typische Bildvorlage entwickelt und auf dem Computer zur Übertragung auf die lichtempfindlichen Aufzeichnungselemente (A, B)-6 bis (A, B)-8 abgespeichert.

Die Übertragung der digitalen Bildinformation, sprich die Erzeugung der Bildmaske (C) auf den lichtempfindlichen Aufzeichnungsschichten (B1) oder (B2) der lichtempfindlichen Aufzeichnungselemente (A, B)-1 bis (A, B)-10 mit Hilfe des Tintenstrahldruckes, wurde im einzelnen wie folgt durchgeführt:

- bei den Beispielen 1 bis 10 mit Hilfe eines vom Graphikcomputer gesteuerten Tintenstrahldruckers Desk Jet Plus von Hewlett Packard, wobei die handelsübliche flüssige Tinte von Hewlett Packard verwendet wurde
- bei den Beispielen 11 bis 20 mit Hilfe eines vom Graphikcomputer gesteuerten Tintenstrahldruckes von IBM, wobei eine Tinte verwendet wurde, die ein Gemisch aus, bezogen auf das Gemisch, 20 Gew.-% Rußpigment und 80 Gew.-% Polyvinylalkohol enthielt
- bei den Beispielen 21 bis 30 wie bei den Beispielen 11 bis 20, nur daß hier eine Tinte verwendet wurde, die ein Gemisch aus, bezogen auf das Gemisch, 15 Gew.-% Rußpigment und 85 Gew.-% eines Styrol-Maleinsäurehalbester-Copolymerisats enthielt
- bei den Beispielen 31 bis 40 wie bei den Beispielen 11 bis 20, nur daß hier eine Tinte verwendet wurde, die ein Gemisch aus, bezogen auf das Gemisch, 18 Gew.-% Rußpigment und 82 Gew.-% eines Methylmethacrylat-Methacrylsäure (70/30)-Copolymerisats enthielt
- bei den Beispielen 41 bis 50 wie bei den Beispielen 11 bis 20, nur daß hier eine Tinte verwendet wurde, die ein Gemisch aus, bezogen auf das Gemisch, 20 Gew.-% einer Abdeck- und Zeichenfarbe (Negropac® der Firma Klimsch, Frankfurt/Main) und 80 Gew.-% Polyvinylalkohol enthielt
- bei den Beispielen 51 bis 60 wie bei den Beispielen 11 bis 20, nur daß hier eine Tinte verwendet wurde, die ein Gemisch aus, bezogen auf das Gemisch, 22 Gew.-% an besagtem Nekropac® und 80 Gew.-% eines Styrol-Maleinsäurehalbester-Copolymerisats enthielt, und
- bei den Beispielen 61 bis 70 wie bei den Beispielen 11 bis 20, nur daß hier eine Tinte verwendet wurde, die ein Gemisch aus, bezogen auf das Gemisch, 20 Gew.-% Rußpigment und 80 Gew.-% des Methylmethacrylat-Methacrylsäure (70/30)-Copolymerisats enthielt.

Bei den Beispielen 1 bis 70 wurden nach dem Auftragen die Tintenbilder bzw. die Bildmasken (C) auf den lichtempfindlichen Aufzeichnungselementen (A, B) getrocknet.

Die Übertragung der digitalen Bildinformation, sprich die Erzeugung der Bildmaske (C) auf den lichtempfindlichen Aufzeichnungselementen (A, B)-1 bis (A B)-10, mit Hilfe der Elektrophotographie wurde im einzelnen wie folgt durchgeführt:

- bei den Beispielen 71 bis 80 wurde eine übliche und bekannte Photokopiertrommel (zylinderförmiges elektrophotographisches Aufzeichnungselement D) in üblicher und bekannter Weise elektrostatisch aufgeladen und unter Drehen der Trommel mit Hilfe eines computergesteuerten Helium-Neon-Lasers (Wellenlänge der Hauptemission : 633 nm) bildmäßig belichtet. Hierbei lag die Schreibgeschwindigkeit bei einer Bildpunktfolgefrequenz von 3,8 MHz bei 193 m•s$^{-1}$, was bei einem Vortrieb in 27 $\mu$m Schritten 42 cm$^2$•s$^{-1}$ an belichteter Fläche entsprach. Nach der bildmäßigen Belichtung wurden die resultierenden Ladungsbilder in üblicher und bekannter Weise mit einem festen feinteiligen Toner (Rußpigment, dispergiert in einem Thermoplasten) betonert. Das resultierende Tonerbild wurde dann auf die lichtempfindlichen Aufzeichnungselemente (A, B)-1 bis (A, B)-10 übertragen, indem man jeweils ein Element und die betonerte Photokopiertrommel in der Art eines Kalanders mit abgestimmter Geschwindigkeit gegeneinander drehte. Nach der Übertragung des Tonerbildes wurde die Photokopiertrommel von gegebenenfalls noch vorhandenen Tonerteilchen befreit und stand dann für die erneute Übertragung der digitalen Information wieder zur Verfügung
- bei den Beispielen 81 bis 90 wurden 10 übliche und bekannte flächenförmige elektrophotographische Aufzeichnungselemente (D) verwendet, welche man nach dem elektrostatischen Aufladen in einem Laser-Recorder der Firma Hope mit Hilfe eines Helium-Neon-Lasers (Wellenlänge $\lambda$ der Hauptemission : 633 nm) bildmäßig belichtete. Hierbei wurde dieselbe Belichtungsgeschwindigkeit wie bei den Beispielen 71 bis 80 ungewandt. Die resultierenden Ladungsbilder wurden in einem Flüssigtonergerät Performer® der Firma Chemco Engineering elektrophoretisch mit dem in Beispiel 1 der US-A-4 661 431 beschriebenen Flüssigtoner betonert. Die betonerten flächenmäßigen elektrophotographischen Aufzeichnungselemente D wurden auf einen Zylinder aufgelegt und in dieser Form mit den zylinderförmigen leichtempfindlichen Aufzeichnungselementen (A, B)-1 bis (A, B)-10 in Kontakt gebracht. Durch Gegeneinanderdrehen des Zylinders und der Elemente wurden dann die Tonerbilder übertragen

- bei dem Beispiel 91 wurde Beispiel 80 wiederholt, nur daß anstelle des verwendeten festen Toners, ein fester Toner verwendet wurde, welcher neben dem Rußpigment pyrogene Kieselsäure enthielt und außerdem noch photochemisch vernetzbar war. Dieser Toner wurde wie folgt erhalten: In einem Mixer wurden

  ● 78 Gew.-Teile eines Polymerisats aus, bezogen auf das Polymerisat, 30 Gew.-% Methacrylsäure, 50 Gew.-% Styrol und 20 Gew.-% Butylmethacrylat, dessen Carboxylgruppen zu ca. 15 Mol.-% mit Glycidylmethacrylat umgesetzt waren

  ● 15 Gew.-Teile Aerosil® (pyrogene Kieselsäure)

  ● 4 Gew.-Teile Rußpigment

  ● 1 Gew.-Teile Stearylpyrrolidino[1,2-α-benzimidazolium]bromid (vgl. die DE-A-38 21 199)

  ● 1 Gew.-Teile Benzildimethylacetal und

  ● 1 Gew.-Teile 2,6-Di-tert.-buyl-p-kresol

  intensiv gemischt, bei 120°C geknetet, extrudiert und vorgemahlen. Durch die Feinmahlung in einer Fließbettgegenstrahlmühle mit Sichtrad und anschließender Sichtung wurden Tonerteilchen zwischen 5 und 10 μm mit einer mittleren Teilchengröße von 8 μm erzeugt. Für die Betonerung wurden 1 Gew.-Teil dieser Tonerteilchen mit 99 Gew.-Teilen eines Eisenpulvers mit Teilchengrößen zwischen 75 und 175 μm, einer mittleren Teilchengröße von 120 μm und sphärischer Form genau eingewogen und während 10 min auf einem Rollenbock aktiviert.

Die Übertragung der digitalen Bildinformation, sprich die Erzeugung der Bildmaske (C) auf den lichtempfindlichen Aufzeichnungselementen (A, B)-1 bis (A, B)-10, mit Hilfe des Thermotransferdrucks wurde im einzelnen wie folgt durchgeführt:

- bei den Beispielen 92 bis 94 wurde eine 4 μm starke und auf ihrer Rückseite mit einer 200 nm starken Zinnschicht bedampfte Polyesterfolie verwendet, welche mit einer 1 μm starken Schicht aus Rußpigment, pyrogener Kieselsäure und Polyvinylalkohol (Pigment/Bindemittel-Mischung) bedeckt war. Die Transferfolie wurde in einem computergesteuerten Thermotransferdrucker zwischen einer Thermokopfzeile und den Elementen (A, B)-1, -2 und -3 eingespannt. Durch sukzessives elektronisches Ansteuern der Thermozeile und Weitertransport von Transferfolie und Element (A, B) wurde die digitale Information zeilenweise übertragen

- bei den Beispielen 95, 96 und 100 wurde im wesentlichen wie bei den Beispielen 92 bis 94 verfahren, nur daß anstelle des wasserlöslichen Bindemittels Polyvinylalkohol ein alkohollösliches Polyamid als Bindemittel in der Pigment/Bindemittel-Mischung der Transferfolie verwendet wurde und daß die Elemente (A, B)-4, -5 und -9 zur Anwendung kamen

- bei den Beispielen 97, 98 und 99 wurde gleichfalls im wesentlichen wie bei den Beispielen 92 bis 94 verfahren, nur daß anstelle des wasserlöslichen Bindemittels Polyvinylalkohol ein in unpolaren organischen Lösungsmitteln lösliches Bindemittel in der Pigment/Bindemittel-Mischung der Transferfolie verwendet wurde und daß die Elemente (A, B)-6, -7 und -8 zur Anwendung kamen

- bei dem Beispiel 101 wurde im wesentlichen wie bei den Beispielen 95, 96 und 100 verfahren, nur daß das Element (A, B)-10 zur Anwendung kam

- bei dem Beispiel 102 wurde im wesentlichen wie bei den Beispielen 97, 98 und 99 verfahren, nur daß das Element (A, B)-10 zur Anwendung kam.

Die in erfindungsgemäßen Verfahrensweise erhaltenen erfindungsgemäßen Aufzeichnungselemente (A, B, C) der Beispiele 1 bis 102 enthielten allesamt eine Bildmaske (C), welche ausgezeichnet mit der jeweiligen lichtempfindlichen Aufzeichnungsschicht (B1) oder (B2) kontrastierte. Es wäre deshalb in einfacher weise möglich gewesen, vorhandene Übertragungsfehler zu erkennen und zu korrigieren, indes waren keine solchen Fehler vorhanden, so daß die Aufzeichnungselemente (A, B, C) sofort zu Druckplatten weiterverarbeitet werden konnten.

Zu diesem Zweck wurden die erfindungsgemäßen Aufzeichnungselemente der Beispiele 1 bis 102 mit üblichen und bekannten UV-Fluoreszenzröhren vollflächig belichtet. Hierbei lag die Belichtungszeit bei den Beispielen 1 bis 4, 9 bis 14, 19 bis 24, 29 bis 34, 39 bis 44, 49 bis 54, 59 bis 64, 69 bis 74, 79 bis 84, 89 bis 95 sowie 100 bis 102 in dem Bereich, welcher für die bildmäßige Belichtung von lichtempfindlichen Aufzeichnungselementen (A, B), die der Herstellung von Tiefdruckplatten dienen, üblich ist (0,5 bis 1 min). Bei den Beispielen 5, 15, 25, 35, 45, 55, 65, 75, 85 und 96 lag die Belichtungszeit in dem Bereich, welcher für die bildmäßige Belichtung von lichtempfindlichen Aufzeichnungselementen (A, B), die der Herstellung von Hochdruckplatten dienen, üblich ist (0,5 bis 2 min). Bei den Beispielen 6 bis 8, 16 bis 18, 26 bis 28, 36 bis 38, 46 bis 48, 56 bis 58, 66 bis 68, 76 bis 78, 86 bis 88 sowie 97 bis 99 lag die Belichtungszeit in dem Bereich, welcher für die bildmäßige Belichtung von lichtempfindlichen Aufzeichnungselementen (A, B), die der Herstellung von Flexodruckplatten dienen, üblich ist (10 bis 20 min).

Bei der vollflächigen Belichtung des erfindungsgemäßen Aufzeichnungselements (A, B, C) des Beispiels 91 wurden die beschichteten Bereiche (C1) der Bildmaske C photochemisch vernetzt.

Nach der Belichtung wurden die erfindungsgemäßen Aufzeichnungselemente (A, B, C) der Beispiele 1 bis 102 mit geeigneten Entwicklerlösungsmitteln entwickelt. Hierbei kamen

- bei den Beispielen 1 bis 3, 10 bis 13, 20 bis 23, 30 bis 33, 40 bis 43, 50 bis 53, 60 bis 63, 70 bis 73, 80 bis 83 und 92 bis 94 [verwendete Elemente (A, B)-1, -2 und -3] Wasser
- bei den Beispielen 4, 5, 9, 14, 15, 19, 24, 25, 29, 34, 35, 39, 44, 45, 49, 54, 55, 59, 64, 65, 69, 74, 75, 79, 84, 85, 89, 95, 96 und 100 [verwendete Elemente (A, B)-4, -5 und 9] ein Gemisch aus n-Butanol und Wasser im Volumenverhältnis von 80 zu 20
- bei den Beispielen 6 bis 8, 16 bis 18, 26 bis 28, 36 bis 38, 46 bis 48, 56 bis 58, 66 bis 68, 76 bis 78, 86 bis 88 sowie 97 bis 99 [verwendete Elemente (A, B)-6, -7 und -8] ein Gemisch aus Shellsol D 60, ein Testbenzin der Firma Esso, und Exxate 700, ein technisches Estergemisch der Firma Exxon, im Volumenverhältnis von 80 zu 20 und
- bei den Beispielen 10, 20, 30, 40, 50, 60, 70, 80, 90, 91, 101 und 102 [verwendetes Element (A, B)-10] 1 %ige wäßrige Natronlauge

als Entwicklerlösungsmittel zur Anwendung.

Für die Entwicklung der vollflächig belicheteten erfindungsgemäßen Aufzeichnungselemente (A, B, C) mit den vorstehend genannten Entwicklerlösungsmitteln werden

- bei den Beispielen 1 bis 4, 9 bis 14, 19 bis 24, 29 bis 34, 39 bis 44, 49 bis 54, 59 bis 64, 69 bis 74, 79 bis 84, 89 bis 95 sowie 100 bis 102 übliche und bekannte, für die Herstellung von Tiefdruckplatten geeignete nyloprint®-Auswaschgeräte
- bei den Beispielen 5, 15, 25, 35, 45, 55, 65, 75, 85 und 96 die üblichen und bekannten, für die Herstellung von Hochdruckplatten geeigneten nyloprint®-Auswaschgeräte und
- bei den Beispielen 6 bis 8, 16 bis 18, 26 bis 28, 36 bis 38, 46 bis 48, 56 bis 58, 66 bis 68, 76 bis 78, 86 bis 88 sowie 97 bis 99 die üblichen und bekannten, für die Herstellung von Flexodruckplatten geeigneten nyloflex® FIII-Auswaschgeräte

verwendet.

Hierbei konnten bei den Beispielen 1 bis 3, 10, 11 bis 13, 20, 30, 40, 41 bis 43, 50, 60, 70, 76 bis 78, 86 bis 88 sowie 92 bis 100 besonders kurze Auswaschzeiten erzielt werden, weil in den betreffenden vollflächig belichteten erfindungsgemäßen Aufzeichnungselementen (A, B, C) die Bildmaske (C) in dem jeweiligen Entwicklungsmittel für die Aufzeichnungsschicht (B) löslich oder besonders gut quellbar war: so waren

- bei den Beispielen 1 bis 3, 11 bis 13, 41 bis 43 und 92 bis 94 die Aufzeichnungsschichten (B1) mit Wasser entwickelbar und die betreffenden Bildmasken (C) in Wasser löslich oder quellbar
- bei den Beispielen 10, 20 und 50 die Aufzeichnungsschichten (B2) mit wäßrig-alkalischer Lösung entwickelbar und die betreffenden Bildmasken (C) in Wasser löslich oder quellbar
- bei den Beispielen 30, 40, 60 und 70 die Aufzeichnungsschichten (B2) mit wäßrig-alkalischer Lösung entwickelbar und die betreffenden Bildmasken (C) in dieser Lösung löslich oder quellbar
- bei den Beispielen 76 bis 78, 86 bis 88 und 97 bis 99 die Aufzeichnungsschichten (B) mit unpolaren organischen Lösungsmitteln entwickelbar und die betreffenden Bildmasken (C) in diesen Lösungsmitteln löslich oder quellbar und
- bei den Beispielen 95, 96 und 100 die Aufzeichnungsschichten (B1) mit Alkoholen entwickelbar und die betreffenden Bildmasken (C) in Alkoholen löslich oder quellbar.

Bei den Beispielen

- 21 bis 23, 31 bis 33, 51 bis 52 sowie 61 bis 62 [mit Wasser entwickelbare Aufzeichnungsschichten (B1), kombiniert mit in wäßrig-alkalischen Lösungen löslichen oder quellbaren Bildmasken (C)]
- 71 bis 73 sowie 81 bis 83 [mit Wasser entwickelbare Aufzeichnungsschichten (B1), kombiniert mit in unpolaren organischen Lösungsmitteln löslichen oder quellbaren Bildmasken (C)]
- 4, 5, 9, 14, 15, 19, 44, 45 und 49 [mit Alkoholen entwickelbare Aufzeichnungsschichten (B1), kombiniert mit in Wasser löslichen oder quellbaren Bildmasken (C)]
- 24, 25, 29, 34, 35, 39, 54, 55, 59, 64, 65 und 69 [mit Alkoholen entwickelbare Aufzeichnungsschichten (B1), kombiniert mit in wäßrigalkalischen Lösungen löslichen Bildmasken (C)]
- 74, 75, 79, 84, 85 und 89 [mit Alkoholen entwickelbare Aufzeichnungsschichten (B1), kombiniert mit in unpolaren organischen Lösungsmitteln löslichen oder quellbaren Bildmasken (C)]

- 6 bis 8, 16 bis 18 sowie 46 bis 48 [mit unpolaren organischen Lösungsmittel entwickelbare Aufzeichnungsschichten (B1), kombiniert mit in Wasser löslichen oder quellbaren Bildmasken (C)] sowie

- 26 bis 28, 36 bis 38, 56 bis 58 sowie 66 bis 68 [mit unpolaren organischen Lösungsmitteln entwickelbare Aufzeichnungsschichten (B1), kombiniert mit in wäßrig-alkalischen Lösungen löslichen oder quellbaren Bildmasken (C)]

wiesen die Bildmasken (C) einerseits und die Aufzeichnungsschichten (B) andererseits ein unterschiedliches Löslichkeits- und/oder Quellverhalten auf, was indes durch eine leichte Verschärfung der Auswaschbedingungen und/oder eine Verlängerung der Auswaschzeit wieder ausgeglichen werden konnte.

Außerdem konnten die Bildmasken (C)

- bei den Beispielen 71 bis 75, 79, 81 bis 85 sowie 89 problemlos mit einem unpolaren organischen Entwicklerlösungsmittel

- bei den Beispielen 4 bis 9, 14 bis 19 sowie 44 bis 49 problemlos mit Wasser

- bei den Beispielen 24 bis 29, 34 bis 39, 54 bis 59 sowie 64 bis 69 problemlos mit einer wäßrig-alkalischen Lösung

in einem Vorwaschschritt oder "prewipe" entfernt werden, bevor der eigentliche Entwicklungsschritt ausgeführt wurde.

Demgegenüber war

- bei den Beispielen 80, 90 und 102 [mit wäßrig-alkalischer Lösung entwickelbare Aufzeichnungsschichten (B2), kombiniert mit in unpolaren organischen Lösungsmitteln löslichen oder quellbaren Bildmasken (C)]

- bei dem Beispiel 91 [mit wäßrig-alkalischer Lösung entwickelbare Aufzeichnungsschicht (B2), kombiniert mit einer photochemisch vernetzten Bildmaske (C)] sowie

- bei dem Beispiel 101 [mit wäßrig-alkalischer Lösung entwickelbare Aufzeichnungsschicht (B2), kombiniert mit einer in Alkoholen löslichen oder quellbaren Bildmaske (C)]

ein besonders großer Unterschied im Löslichkeits- und/oder Quellverhalten der Bildmasken (C) einerseits und der Aufzeichnungsschichten (B2) andererseits von vornherein besonders vorteilhaft, weil ja die beschichteten Bereiche (C1) der Bildmasken (C) auf den Bildbereichen der entwickelten Aufzeichnungsschichten (B2) zurückbleiben sollten, damit die Oberflächeneigenschaften der in erfindungsgemäßer Verfahrensweise erhaltenen Tiefdruckplatten gezielt variiert werden konnten. Genau dies wurde dann auch mit Hilfe der erfindungsgemäßen Verfahrensweise besonders einfach und elegant erreicht.

Für die Vergleichsversuche V1 bis V10 mußten die lichtempfindlichen Aufzeichnungselemente (A, B)-1 bis (A, B)-10 mit einer 2 $\mu$m dicken Deckschicht (D) versehen werden, welche verhindern sollte, daß die für die bildmäßige Kontaktbelichtung mit aktinischem Licht verwendeten Positiv- oder Negativfilmvorlagen nicht an der Oberfläche der lichtempfindlichen Aufzeichnungsschichten (B) festklebten.

Das Aufbringen der Deckschichten (DS) erfolgte in üblicher und bekannter Weise durch Gießen der Deckschichten (DS) aus ihren Lösungen auf Polyethyleneterephthalatfolien (PE), Trocknen der hierbei resultierenden Naßschichten (DS), Aufkaschieren der so erhaltenen Deckelemente (DS, PE) mit der Seite der Deckschicht (D) auf die Oberfläche der lichtempfindlichen Aufzeichnungsschichten (B) unter Erhalt lichtempfindlicher Aufzeichnungselemente (A, B, DS, PE) und Abziehen der Polyethylenterephthalatfolien (PE).

Dabei wurden

- bei den Vergleichsversuchen V1 bis V3 und V10 Deckschichten (DS) aus dem Polyvinylalkohol Mowiol® 04-M1 der Firma Hoechst und

- bei den Vergleichsversuchen V4 bis V9 Deckschichten (DS) aus dem Polyamid Makromelt® 9000 der Firma Henkel

verwendet.

Für die Vergleichsversuche V1 bis V4 sowie V9 und V10 wurde als Vorlage eine für das Tiefdruckgebiet typische Rasterbildfolie gewählt, deren Motiv exakt mit der Computergraphik übereinstimmte, welche für die Durchführung der Beispiele 1 bis 4, 9 bis 14, 19 bis 24, 29 bis 34, 39 bis 44, 49 bis 54, 59 bis 64, 69 bis 74, 79 bis 84, 89 bis 95 sowie 100 bis 102 entwickelt und abgespeichert worden war.

Für den Vergleichsversuch V5 wurde der bekannte FOGRA Ppäzionsmeßstreifen für den Zeitungsdruck PMS-Z als Vorlage verwendet.

Für die Vergleichsversuche V6 bis V8 wurde als Vorlage eine für das Flexodruckgebiet typische Negativfolie gewählt, deren Motiv exakt mit der Computergraphik übereinstimmte, welche für die Durchführung der Beispiele 6 bis 8, 16 bis 18, 26 bis 28, 36 bis 38, 46 bis 48, 56 bis 58, 66 bis 68, 76 bis 78, 86 bis 88 sowie 97 bis 99 entwickelt und abgespeichert worden war.

Vor der weiteren Verwendung wurden die herkömmlichen Elemente (A, B, DS)-6 bis -8 während 2 Minuten von ihrer Rückseite her, d.h. durch den Träger (A) hindurch in üblicher und bekannter Weise vollflächig mit aktinischem Licht vorbelichtet.

Die zehn herkömmlichen Aufzeichnungselemente (A, B, DS)-1 bis -10 wurden für die Durchführung der Vergleichsversuche V1 bis V10 auf Druckzylinder geeigneter Durchmesser aufgespannt und hiernach mit Hilfe der entsprechenden, vorstehend genannten Folien bildmäßig belichtet, indem man die Folien oder Bildmasken mit einer umgelenkten transparenten Folie, welche etwa ein zehntel des jeweiligen Zylinderumfangs umspannte, fest auf das betreffende Element aufgepreßte und weitertransportierte, wobei die Aufpreßstelle mit aktinischem Licht bestrahlt wurde.

Nach der Belichtung wurden die herkömmlichen Aufzeichnungselemente (A, B, DS)-1 bis -10 mit
- Wasser (Vergleichsversuche V1 bis V3)
- einem Gemisch aus n-Butanol und Wasser im Volumenverhältnis von 80 zu 20 (Vergleichsversuche V4, V5 und V9)
- einem Gemisch aus Shellsol D60, ein Testbenzin der Firma Esso, Exxate 700, ein technisches Estergemisch der Firma Exxon, und 2-Ethylhexanol im Volumenverhältnis von 60 zu 20 zu 20 (Vergleichsversuche V6 bis V8) und
- 1 %iger wäßriger Natronlauge (Vergleichsversuch V10)
in den vorstehend genannten Auswaschgeräten entwickelt.

Im Anschluß an die Entwicklung wurden die in erfindungsgemäßer und die in üblicher und bekannter Weise hergestellten Tief-, Hoch- und Flexodruckplatten getrocknet und im Falle der Flexodruckplatten (Beispiele 6 bis 8, 16 bis 18, 26 bis 28, 36 bis 38, 46 bis 48, 56 bis 58, 66 bis 68, 76 bis 78, 86 bis 88, 97 bis 99 sowie die Vergleichsversuche V6 bis V8) mit dem aktinischen Licht einer Entkeimungslampe vollflächig nachbelichtet.

Schon der Vergleich der erfindungsgemäßen Herstell- und Weiterverarbeitungsverfahren der Beispiele 1 bis 102 mit den üblichen und bekannten Verfahren der Vergleichsversuche V1 bis V10 macht deutlich, daß die erfindungsgemäßen Verfahren variabler eleganter, rationeller und schneller und dabei auch nach präziser als die herkömmlichen waren: So ist es nicht mehr länger notwendig Deckschichten (DS) auf der Oberfläche klebriger lichtempfindlichen Aufzeichnungsschichten (B) aufzubringen - ganz im Gegenteil bringt bei den erfindungsgemäßen Verfahren die Oberflächenklebrigkeit deutliche Vorteile mit sich. Außerdem können die Bildvorlagen direkt am Graphikcomputer entwickelt und per Datenleitung in den reprographischen Betrieb oder die Klischeeanstalt übertragen und dort - ohne Zwischenschaltung einer Folie - direkt in druckfähige Erzeugnisse umgesetzt werden. Hierbei können die erfindungsgemäßen Verfahren sowohl mit flächenförmigen als auch mit zylinderförmigen Aufzeichnungselementen (A, B) durchgeführt werden, was ein wesentlicher Vorteil ist, der die ohnehin schon vorzügliche Varibilität der erfindungsgemäßen Herstell- und Weiterverarbeitungsverfahren noch weiter steigert.

Insbesondere manifestieren sich besondere Vorteile der Erfindung an den erfindungsgemäßen Aufzeichnungselementen (A, B, C). Diese weisen nicht nur eine nahezu oder völlig fehlerfreie Bildmaske (C) auf, welche der jeweiligen Computergraphik exakt entspricht, sondern sie bieten auch wegen des optischen Kontrastes zwischen der Bildmaske (C) und den Aufzeichnungsschichten (B) die Möglichkeit zur rechtzeitigen Korrektur von übertragungsfehlern, falls diese doch einmal vorkommen sollten.

Vor allem aber treten die besonderen Vorteile der Erfindung an den aus den erfindungsgemäßen Aufzeichnungselementen (A, B, C) hergestellten Tief-, Hoch- und Flexodruckplatten zu Tage, was sich auch noch durch den Vergleich mit Tief-, Hoch- und Flexodruckplatten untermauern läßt, welche man in üblicher und bekannter Weise hergestellt hat.

Welche Beispiele hierbei mit welchen Vergleichsversuchen im einzelnen direkt verglichen werden können, geht aus der letzten Spalte der Tabelle hervor.

Bei diesem Vergleich wird insbesondere folgendes deutlich:

1. Während die in erfindungsgemäßer Verfahrensweise aus den Aufzeichnungselementen (A, B)-1 bis -4 und (A, B)-9 hergestellten Tiefdruckplatten das Motiv der Computergraphik völlig exakt wiedergeben, eine vorzügliche, glatte Oberfläche aufweisen und beim Drucken auf einer üblichen und bekannten Tiefdruckmaschine nicht tonen, sehr gute Farbübertragungseigenschaften zeigen, eine Zunahme der Kratzer in der Größenordnung von etwa 20 pro Stunde aufweisen und eine Auflagenstabilität (bestimmt gemäß dem AT2-Test mit Hilfe des Standardabriebgerätes der Firma Schröder, D-6940 Weinheim) im Bereich von 2 Millionen haben, lassen die in üblicher und bekannter Weise hergestellten Tiefdruckplatten der Vergleichsversuche V1 bis V4 und V9 noch deutlich zu wünschen übrig: Die Tiefdruckplatten der Vergleichsversuche geben das Motiv der Bildvorlage längst nicht so gut wieder wie die Tiefdruckplatten der betreffenden Beispiele (vgl. die Tabelle), sie haben eine vergleichsweise rauhe Oberfläche und beim Drucken auf der Tiefdruckmaschine neigen sie zum Tonen, zeigen nur Farbübertragungseigenschaften mittlerer Güte, weisen eine Zunahme der Kratzer in der Größenordnung von 130 bis 150 pro Stunde auf und haben eine in gleicher Weise wie bei den Beispielen bestimmte Auflagenstabiliät von 150 000, was deutlich unter den 2 Millionen der Beispiele liegt.

2. Besonders offen tritt der Qualitätsunterschied bei dem Vergleich zwischen den in erfindungsgemäßer Verfahrensweise aus dem positiv arbeitenden Aufzeichnungselement (A, B)-10 hergestellten Tiefdruckplatten und der Tiefdruckplatte des Vergleichsversuchs V10 hervor:

Während die Vergleichsplatte die Bildvorlage nur in befriedigender Qualität wiedergibt, eine vergleichsweise rauhe, unmodifizierte, beim Drucken tonende Oberfläche mit lediglich befriedigenden Farbübertragungseigenschaften hat und eine Auflagenstabilität nach dem AT2-Test im Bereich von 500 000 erreicht, weisen die Tiefdruckplatten der Beispiele 80, 90, 91, 101 und 102 eine glatte, besonders abriebfeste, beim Drucken nicht tonende, modifizierte Oberfläche mit vorzüglichen Farbübertragungseigenschaften sowie eine exakte Wiedergabe des Motivs der Computergraphik auf, weswegen die Tiefdruckplatten der genannten Beispiele, besonders vorzügliche Druckerzeugnisse in einer Auflage liefern, welche 1 Million weit übersteigt.

Hierbei wurde bei der Tiefdruckplatte des Beispiels 91 überhaupt keine Bildung von Kratzern mehr beobachtet.

3. Ein ähnlicher Qualitätsunterschied läßt sich auch anhand des Vergleichs zwischen den in erfindungsgemäßer Verfahrensweise aus dem Aufzeichnungselement (A, B)-5 hergestellten Hochdruckplatten und der Hochdruckplatte des Vergleichsversuchs V5 nachweisen:

Während die Hochdruckplatten der Beispiele (vgl. die Tabelle) vorzügliche Zeitungsdrucke in besonders hoher Auflage liefern, läßt die Wiedergabequalität der Vergleichsplatte deutlich zu wünschen übrig, weswegen die Zeitungsdrucke von lediglich befriedigender Qualität sind.

4. Auch die Flexodruckplatten der Vergleichsversuche V6 bis V8 machen keine Ausnahme und fallen in ihrer Wiedergabequalität und Auflagenstabilität gegenüber den in erfindungsgemäßer Verfahrensweise aus den Aufzeichnungselementen (A, B)-6 bis -8 hergestellten Flexodruckplatten der Beispiele (vgl. die Tabelle) ganz deutlich ab.

**Patentansprüche**

1. Gegenüber ultraviolettem und/oder sichtbarem aktinischem Licht empfindliches Aufzeichnungselement, enthaltend

   A) einen dimensionsstabilen Träger,

   B) eine negativ arbeitende oder positiv arbeitende lichtempfindliche Aufzeichnungsschicht (B1) oder (B2) und

   C) eine der Oberfläche der lichtempfindlichen Aufzeichnungsschicht (B1) oder (B2) direkt aufliegende Bildmaske, welche ein reliefartiges Muster aus beschichteten Bereichen (C1) und unbeschichteten Bereichen (C2) darstellt, wobei die beschichteten Bereiche (C1) gegenüber dem jeweils zu verwendenden aktinischen Licht im wesentlichen undurchlässig sind,

   dadurch gekennzeichnet, daß die beschichteten Bereiche (C1) des reliefartigen Musters oder der Bildmaske (C) aus Flüssigkeitströpfchen oder festen Partikeln bestehen, welche auf die Oberfläche der lichtempfindlichen Aufzeichnungsschicht (B1) oder (B2) übertragen worden sind.

2. Das lichtempfindliche Aufzeichnungselement (A, B, C) nach Anspruch 1, dadurch gekennzeichnet, daß es sich bei den Flüssigkeitströpfchen und den festen Partikeln um übertragene Flüssigtonertröpfchen oder feste Tonerpartikel, wie sie in der Elektrophotographie verwendet werden, um aufgespritzte Tintentröpfchen oder getrocknete oder wiedererstarrte feste Tintenpartikel, wie sie durch Tintenstrahldrucker erzeugt werden, oder um aufgedampfte oder aufgeschmolzene, flüssige oder wiedererstarrte Pigment- oder Pigment/Bindemittel-Tröpfchen und -Partikel handelt, wie sie mit Hilfe der Thermotransferdruckmethoden erzeugt werden.

3. Das lichtempfindliche Aufzeichnungselement (A, B, C) nach Anspruch 1 oder 2, dadurch gekennzeichnet, daß es eine negativ arbeitende photovernetzbare lichtempfindliche Aufzeichnungsschicht (B1), eine negativ arbeitende, photopolymerisierbare lichtempfindliche Aufzeichnungsschicht (B1) oder eine photoabbaubare positiv arbeitende lichtempfindliche Aufzeichnungsschicht (B2) enthält.

4. Das lichtempfindliche Aufzeichnungselement (A, B, C) nach einem der Ansprüche 1 bis 3, dadurch gekennzeichnet, daß die Oberfläche seiner lichtempfindlichen Aufzeichnungsschicht (B1) oder (B2) klebrig ist.

EP 0 465 949 A2

**5.** Verkaufsfertiges Produkt, umfassend mindestens ein lichtempfindliches Aufzeichnungselement (A, B, C) gemäß einem der Ansprüche 1 bis 4 in einer lichtundurchlässigen, nicht verformbaren Verpackung.

**6.** Verwendung von Tonern, wie sie in der Elektrophotographie angewandt werden, von Tinten, wie sie in Tintenstrahldruckern angewandt werden, und von verdampfbaren und/oder schmelzbaren Pigmenten und/oder Pigment/Bindemittel-Mischungen, wie sie im Thermotransferdruck Verwendung finden, für die Herstellung lichtempfindlicher Aufzeichnungselemente.

**7.** Verwendung von Tonern, wie sie in der Elektrophotographie angewandt werden, oder von Pigmenten oder Pigment/Bindemittel-Mischungen, wie sie im Thermotransferdruck angewandt werden, für die Verbesserung des Abriebverhaltens von auf photomechanischem Wege hergestellten Druckplatten beim Drucken und Photoresisten bei der Verarbeitung zu Leiterplatten.

**8.** Verfahren zur Herstellung abriebfester Druckplatten und Photoresiste aus lichtempfindlichen Aufzeichnungselementen, welche

A) einen dimensionsstabilen Träger und
B2) eine positiv arbeitende lichtempfindliche Aufzeichnungsschicht, welche gegenüber ultraviolettem und/oder sichtbarem aktinischem Licht empfindlich ist,

aufweisen, durch

(1) Aufbringen einer Bildmaske (C) auf der Oberfläche der lichtempfindlichen Aufzeichnungsschicht (B2),
(2) vollflächiges Belichten des hierdurch resultierenden, lichtempfindlichen Aufzeichnungselements (A, B2, C) mit ultraviolettem und/oder sichtbarem aktinischem Licht und
(3) Auswaschen (Entwickeln) der belichteten Bereiche der Aufzeichnungsschicht (B2) mit einem Entwicklerlösungsmittel,

dadurch gekennzeichnet, daß man hierbei die Bildmaske (C) als ein reliefartiges Muster aus beschichteten Bereichen (C1) und unbeschichteten Bereichen (C2) direkt auf der Oberfläche der lichtempfindlichen Aufzeichnungsschicht (B2) erzeugt, wobei die beschichteten Bereiche (C1) gegenüber dem jeweils verwendeten aktinischen Licht im wesentlichen undurchlässig sind und beim Auswaschen nicht zusammen mit den belichteten Bereichen der Aufzeichnungsschicht (B2) entfernt werden, sondern auf den Bildbereichen resultierenden Druckplatten und Photoresiste zurückbleiben.

**9.** Das Verfahren zur Herstellung abriebfester Druckplatten und Photoresiste nach Anspruch 8, dadurch gekennzeichnet, daß man hierbei die beschichteten Bereiche (C1) der Bildmaske (C) durch

(4) das bildmäßige Auftragen fester, geschmolzener oder in Flüssigkeiten gelöster oder dispergierter Partikel erzeugt.

**10.** Das Verfahren zur Herstellung abriebfester Druckplatten und Photoresiste nach Anspruch 8 oder 9, dadurch gekennzeichnet, daß die Oberfläche der lichtempfindlichen Aufzeichnungsschicht (B2) klebrig ist.

**11.** Das Verfahren zur Herstellung abriebfester Druckplatten und Photoresiste nach Anspruch 9 oder 10, dadurch gekennzeichnet, daß es sich bei den festen Partikel entweder um Toner, wie sie in der Elektrophotographie verwendet werden, oder um erstarrte Pigment- und/oder Pigment/Bindemittel-Partikel handelt, wie sie im Thermotransferdruck verwendet werden, wobei die festen Partikel sehr harte, sehr feinteilige Füllstoffteilchen enthalten.

**12.** Das Verfahren zur Herstellung abriebfester Druckplatten und Photoresiste nach Anspruch 11, dadurch gekennzeichnet, daß es sich bei den sehr harten und sehr feinteiligen Füllstoffen um pyrogene Kieselsäure und/oder um Quarz-, Diamant-, Siliciumcarbid- und/oder Wolframcarbidstaub handelt.

**13.** Das Verfahren zur Herstellung abriebfester Druckplatten und Photoresiste nach einem der Ansprüche 8 bis 12, dadurch gekennzeichnet, daß die im Verfahrensschritt (1) aufgetragenen beschichteten Bereiche (C1) der Bildmaske (C)

(5) im Verfahrensschritt (2) photochemisch vernetzt und/oder
(6) nach dem Verfahrensschritt (3) thermisch vernetzt und/oder in die Oberfläche der entwickelten Aufzeichnungsschicht (B2) eingebrannt werden.

26

**14.** Das Verfahren zur Herstellung abriebfester Druckplatten und Photoresisten nach einem der Ansprüche 8 bis 13, dadurch gekennzeichnet, daß man hierbei in an sich bekannter Weise auf der Oberfläche eines elektrophotographischen Aufzeichnungselements (D) durch Aufladen mit einer Hochspannungsentladungskorona, bildmäßiges Belichten mit aktinischem Licht und Betonern ein Tonerbild aus Tonerpartikeln erzeugt, wonach man dieses Tonerbild direkt auf die Oberfläche der lichtempfindlichen Aufzeichnungsschicht (B2) des lichtempfindlichen Aufzeichnungselements (A, B2) überträgt.

**15.** Das Verfahren zur Herstellung abriebfester Druckplatten und Photoresiste nach Anspruch 14, dadurch gekennzeichnet, daß man hierbei ein flächenförmiges elektrophotographisches Aufzeichnungselement (D) verwendet und daß das hierauf erzeugte Tonerbild entweder stempelartig auf die lichtempfindliche Aufzeichnungsschicht (B2) des lichtempfindlichen Aufzeichnungselements (A, B2) übertragen oder von der Oberfläche der lichtempfindlichen Aufzeichnungsschicht (B2) eines über das Tonerbild hinweggerollten zylinderförmigen lichtempfindlichen Aufzeichnungselements (A, B2) aufgenommen wird.

**16.** Das Verfahren zur Herstellung abriebfester Druckplatten und Photoresiste nach Anspruch 14, dadurch gekennzeichnet, daß man hierbei ein zylinderförmiges elektrophotographisches Aufzeichnungselement (D) verwendet und daß man das hierauf erzeugte Tonerbild entweder durch Aufwalzen auf die Oberfläche der lichtempfindlichen Aufzeichnungsschicht (B2) eines flächenförmiges lichtempfindlichen Aufzeichnungselements (A, B2) oder auf die Oberfläche der lichtempfindlichen Aufzeichnungsschicht (B2) eines zylinderförmigen lichtempfindlichen Aufzeichnungselements (A, B) überträgt, indem man das zylinderförmige elektrophotographische Aufzeichnungselement (D) und das zylinderförmige lichtempfindliche Aufzeichnungselement (A, B2) in der Art eines Kalanders gegeneinander dreht.

**17.** Das Verfahren zur Herstellung abriebfester Druckplatten und Photoresiste nach einem der Ansprüche 14 bis 16, dadurch gekennzeichnet, daß das elektrophotographische Aufzeichnungselement (D) mittels einer computergesteuerten Laserlichtquelle bildmäßig belichtet wird.

**18.** Das Verfahren zur Herstellung abriebfester Druckplatten und Photoresiste nach einem der Ansprüche 8 bis 13, dadurch gekennzeichnet, daß man hierbei die Pigment- und/oder Pigment/Bindemittel-Partikel von einer Folie aus, welche eine Pigment- oder eine Pigment/Bindemittel-Schicht enthält, auf die Oberfläche der lichtempfindlichen Aufzeichnungsschicht (B2) des lichtempfindlichen Aufzeichnungselements (A, B2) überträgt.

**19.** Das Verfahren zur Herstellung abriebfester Druckplatten und Photoresiste nach Anspruch 18, dadurch gekennzeichnet, daß man hierbei zum Zwecke der Übertragung die Folie von ihrer der Pigment- oder Pigment/Bindemittel-Schicht abgewandten Seite her mittels eines computergesteuerten Thermokopfes oder mittels einer computergesteuerten Laserlichtquelle erwärmt.

**20.** Verfahren zur Herstellung eines lichtempfindlichen Aufzeichnungselements, das
A) einen dimensionsstabilen Träger,
B) eine negativ arbeitende oder positiv arbeitende Aufzeichnungsschicht (B1) oder (B2), welche gegenüber ultraviolettem und/oder sichtbarem aktinischem Licht empfindlich ist, und
C) eine der Oberfläche der lichtempfindlichen Aufzeichnungsschicht (B1) oder (B2) direkt aufliegende Bildmaske, welche ein reliefartiges Muster aus beschichteten Bereichen (C1) und unbeschichteten Bereichen (C2) darstellt, wobei die beschichteten Bereiche (C1) gegenüber dem jeweils zu verwendenden aktinischen Licht im wesentlichen undurchlässig sind,
enthält, durch Erzeugen der Bildmaske (C) auf der Oberfläche der lichtempfindlichen Aufzeichnungsschicht (B1) oder (B2), dadurch gekennzeichnet, daß man hierbei das reliefartige Muster oder die Bildmaske (C) direkt durch bildmäßiges Auftragen von Flüssigkeitströpfchen oder von festen, geschmolzenen oder in Flüssigkeiten dispergierten oder gelösten Partikel erzeugt, wobei man die in Flüssigkeiten dispergierten oder gelösten Partikel nach ihrem Auftragen trocknen und die geschmolzenen Partikel nach ihrem Auftragen erstarren läßt.

**21.** Verfahren zur Herstellung von Druckplatten und Photoresisten aus lichtempfindlichen Aufzeichnungselementen, welche
(A) einen dimensionsstabilen Träger und
(B) eine negativ arbeitende oder eine positiv arbeitende lichtempfindliche Aufzeichnungsschicht (B1) oder (B2), welche gegenüber ultraviolettem und/oder sichtbarem aktinischem Licht empfindlich ist,

aufweisen, durch

(1) Aufbringen einer Bildmaske (C) auf der Oberfläche der lichtempfindlichen Aufzeichnungsschicht (B1), wobei die Bildmaske (C) ein reliefartiges Muster aus beschichteten Bereichen (C1) und unbeschichteten Bereichen (C2) darstellt, deren beschichteten Bereiche (C1) gegenüber dem jeweils verwendeten aktinischen Licht im wesentlichen undurchlässig sind,

(2) vollflächiges Belichten des hierbei resultierenden lichtempfindlichen Aufzeichnungselements (A, B, C) mit aktinischem Licht und

(3) Auswaschen (Entwickeln) des belichteten Aufzeichnungselements mit einem Entwicklerlösungsmittel, wobei die beschichteten Bereichen (C1) der Bildmaske (C) zusammen mit den unbelichteten Bereichen der Aufzeichnungsschicht (B1) oder den belichteten Bereichen der Aufzeichnungsschicht (B2) völlig weggewaschen werden,

dadurch gekennzeichnet, daß man hierbei die Bildmaske (C) direkt durch bildmäßiges Auftragen von Flüssigkeitströpfchen und von festen oder geschmolzenen oder in Flüssigkeiten dispergierten oder gelösten Partikeln erzeugt, wobei man die in Flüssigkeiten gelösten oder dispergierten Partikel nach ihrem Auftragen trocknen und die geschmolzenen Partikel nach ihrem Auftragen erstarren läßt.

22. Das Verfahren nach Anspruch 20 oder 21, dadurch gekennzeichnet, daß es sich bei den Flüssigkeitströpfchen und den festen oder geschmolzenen oder in FLüssigkeiten gelösten oder dispergierten Partikeln

(i) um Toner handelt, wie sie in der Elektrophotographie verwendet werden,

(ii) um Tinten handelt, wie sie in Tintenstrahldruckern verwendet werden, oder

(iii) um Pigmente und/oder Pigment/Bindemittel-Mischungen handelt, wie sie beim Thermotransferdruck verwendet werden.

23. Das Verfahren nach Anspruch 22, dadurch gekennzeichnet, daß man hierbei in an sich bekannter Weise auf der Oberfläche eines elektrophotographischen Aufzeichnungselements (D) durch Aufladen mit einer Hochspannungsentladungskorona, bildmäßigem Belichten mit aktinischem Licht und Betonern ein Tonerbild aus Flüssigtonertröpfchen oder Tonerpartikeln erzeugt, wonach man dieses Tonerbild direkt auf die Oberfläche der lichtempfindlichen Aufzeichnungsschicht (B1) oder (B2) des lichtempfindlichen Aufzeichnungselements (A, B) überträgt.

24. Das Verfahren nach Anspruch 23, dadurch gekennzeichnet, daß man hierbei ein flächenförmiges elektrophotographisches Aufzeichnungselement (D) verwendet, und daß das hierauf erzeugte Tonerbild entweder stempelartig auf die Oberfläche der lichtempfindlichen Aufzeichnungsschicht (B1) oder (B2) des flächenförmigen lichtempfindlichen Aufzeichnungselements (A, B) übertragen oder von der Oberfläche der lichtempfindlichen Aufzeichnungsschicht (B1) oder (B2) eines über das Tonerbild hinweggerollten zylinderförmigen lichtempfindlichen Aufzeichnungselements (A, B) aufgenommen wird.

25. Das Verfahren nach Anspruch 23, dadurch gekennzeichnet, daß man hierbei ein zylinderförmiges elektrophotographisches Aufzeichnungselement (D) verwendet, und daß man das hierauf erzeugte Tonerbild entweder durch Aufwalzen auf die Oberfläche der lichtempfindlichen Aufzeichnungsschicht (B1) oder (B2) eines flächenförmigen lichtempfindlichen Aufzeichnungselements (A, B) oder auf die Oberfläche der lichtempfindlichen Aufzeichnungsschicht (B1) oder (B2) eines zylinderförmigen lichtempfindlichen Aufzeichnungselements (A, B) überträgt, indem man das zylinderförmige elektrophotographische Aufzeichnungselement (D) und das zylinderförmige lichtempfindliche Aufzeichnungselement (A, B) in der Art eines Kalanders gegeneinander dreht.

26. Das Verfahren nach einem der Ansprüche 23 bis 25, dadurch gekennzeichnet, daß man hierbei das elektrophotographische Aufzeichnungselement (D) mittels einer computergesteuerten Laserlichtquelle bildmäßig belichtet.

27. Das Verfahren nach Anspruch 22, dadurch gekennzeichnet, daß man hierbei

(ii) die Flüssigkeitströpfchen sowie die geschmolzenen und die in Flüssigkeiten dispergierten oder gelösten Partikel bzw. die Tinten mittels computergesteuerter Tintenstrahldrucker und

(iii) die Pigment- und/oder Pigment/Bindemittel-Tröpfchen oder -Partikel von einer Folie aus, welche eine Pigment- oder eine Pigment/Bindemittel-Schicht enthält und welche von ihrer der Pigment- oder Pigment/Bindemittel-Schicht abgewandten Seite her mittels eines computergesteuerten Thermokopfes oder mittels einer computergesteuerten Laserlichtquelle erwärmt wird,

28

auf die Oberfläche der lichtempfindlichen Aufzeichnungsschicht (B1) oder (B2) des lichtempfindlichen Aufzeichnungselements (A, B) überträgt.

28. Das Verfahren nach einem der Ansprüche 20 bis 27, dadurch gekennzeichnet, daß die Oberfläche der lichtempfindlichen Aufzeichnungsschicht (B1) oder (B2) klebrig ist.

29. Gerät zur Durchführung des Verfahrens gemäß einem der Ansprüche 8 bis 14, 16, 17, 20 bis 23, 25, 26 oder 28, welches
    (D) ein zylinderförmiges elektrophotographisches Aufzeichnungselement mit
    (D1) einem elektrisch leitenden dimensionsstabilen Träger und
    (D2) einer organischen oder anorganischen photoleitenden Aufzeichnungsschicht,
    (E) mindestens eine Vorrichtung zum Erzeugen einer Hochspannungsentladungskorona zum elektrostatischen Aufladen des zylinderförmigen elektrophotographischen Aufzeichnungselements (D),
    (F) mindestens eine Vorrichtung für die bildmäßige Belichtung der elektrostatisch aufgeladenen photoleitenden Aufzeichnungsschicht (D2) mit aktinischem Licht,
    (G) mindestens eine Vorrichtung zum Betonern des auf der elektrostatisch aufgeladenen photoleitenden Aufzeichnungsschicht (D2) durch bildmäßiges Belichten erzeugten Ladungsbildes,
    (H) mindestens eine Vorrichtung zum Übertragen des Tonerbildes auf eine andere Oberfläche und
    (I) mindestens eine Vorrichtung zum kontrollierten Drehen des zylinderförmigen elektrophotographischen Aufzeichnungselements (D)
    umfaßt, dadurch gekennzeichnet, daß das Gerät darüber hinaus zumindest ein zylinderförmiges oder flächenförmiges, gegenüber ultraviolettem und/oder sichtbarem aktinischem Licht empfindliches Aufzeichnungselement (A, B) mit
    (A) einem dimensionsstabilen Träger und
    (B) einer negativ arbeitenden oder positiv arbeitenden lichtempfindlichen Aufzeichnungsschicht (B1) oder (B2)
    enthält, welches in direktem Kontakt mit dem zylinderförmigen elektrophotographischen Aufzeichnungselement (D) steht und hiergegen mit abgestimmter relativer Geschwindigkeit bewegt werden kann.

30. Das Gerät nach Anspruch 29, dadurch gekennzeichnet, daß es noch
    (J) mindestens eine Vorrichtung zum Entfernen des nach dem Übertragen gegebenenfalls noch vorhandenen überschüssigen Toners von der Oberfläche des zylinderförmigen elektrophotographischen Aufzeichnungselements (D),
    (K) mindestens eine Vorrichtung für die kontrollierte Bewegung des zylinderförmigen oder flächenförmigen lichtempfindlichen Aufzeichnungselements (A, B),
    (L) mindestens eine Vorrichtung zum vollflächigen Belichten des bildmäßig betonerten lichtempfindlichen Aufzeichnungselements (A, B, C) mit aktinischem Licht,
    (M) mindestens eine Vorrichtung zum Auswaschen der belichteten oder unbelichteten Bereiche der bildmäßig betonerten und vollflächig belichteten Aufzeichnungsschicht (B1) oder (B2) des Aufzeichnungselements (A, B, C),
    (N) mindestens eine Vorrichtung zum Trocknen des ausgewaschenen Aufzeichnungselements (A, B, C) und/oder
    (O) mindestens eine Vorrichtung, welche dem Zuführen des lichtempfindlichen Aufzeichnungselements (A, B) zum elektrophotographischen Aufzeichnungselement (D) sowie zum Abführen des lichtempfindlichen Aufzeichnungselements (A, B, C) vom elektrophotographischen Aufzeichnungselement (D) dient,
    enthält.

31. Das Gerät nach Anspruch 29 oder 30, dadurch gekennzeichnet, daß das zylinderförmige lichtempfindliche Aufzeichnungselement (A, B) und das zylinderförmige elektrophotographische Aufzeichnungselement (D) in der Art eines Kalanders gegeneinander gedreht werden.

32. Das Gerät nach einem der Ansprüche 29 bis 31, dadurch gekennzeichnet, daß die Vorrichtung (F) eine computergesteuerte Laserlichtquelle ist.

33. Das Gerät nach einem der Ansprüche 29 bis 32, dadurch gekennzeichnet, daß die Oberfläche der lichtempfindlichen Aufzeichnungsschicht (B1) oder (B2) des lichtempfindlichen Aufzeichnungselements (A, B) klebrig ist.

29

**34.** Verwendung des Geräts gemäß einem der Ansprüche 29 bis 33 für die Herstellung nahtloser Tief-, Offset-, Hoch- und Flexodruckzylinder für den Endlosdruck.